# DEMANDE DE BREVET EUROPEEN

(11) **EP 2 765 613 A1**
(43) Date de publication de la demande: **13.08.2014**
(21) Numéro de dépôt: 14154710.9
(22) Date de dépôt: 11.02.2014
(51) Int. Cl.: H01L 29/786, H01L 29/66

(54) **Procédé de fabrication d'un transistor**

(30) Priorité: 11.02.2013 FR 1351140
(71) Demandeur: COMMISSARIAT A L'ENERGIE ATOMIQUE ET AUX ENERGIES ALTERNATIVES, 75015 Paris (FR); STMicroelectronics (Crolles 2) SAS, 38920 Crolles (FR); STmicroelectronics SA, 92120 Montrouge (FR)
(72) Inventeur: Niebojewski, Heimanu, 38000 Grenoble (FR); Morand, Yves, 38000 Grenoble (FR); Vinet, Maud, 38140 Rives (FR)
(74) Mandataire: Hautier, Nicolas

(57) **Abrégé**

La présente invention a notamment pour objet un procédé de fabrication d'un transistor comprenant la formation d'un empilement de couches de type semiconducteur-sur-isolant comportant au moins un substrat (112), surmonté d'une première couche isolante (114) et d'une couche active destinée à former un canal (180) pour le transistor, le procédé comprenant en outre la formation d'un empilement de grille sur la couche active et la réalisation d'une source et d'un drain, caractérisé en ce que la réalisation de la source et du drain comprend au moins les étapes suivantes:
la formation de part et d'autre de l'empilement de grille de cavités (440) par au moins une étape de gravure de la couche active, de la première couche isolante (114) et d'une partie du substrat (112) sélectivement à l'empilement de grille de manière à retirer la couche active, la première couche isolante (114) et une portion du substrat (112) en dehors de zones situées en dessous de l'empilement de grille,
la formation d'une deuxième couche isolante (118) comprenant la formation d'un film isolant sur les surfaces mises à nu du substrat (112), de manière à former avec la première couche isolante (114) une couche isolante (118);
la mise à nu des extrémités latérales du canal (180);
le remplissage des cavités (440) par épitaxie pour former la source et le drain.

## Description

### DOMAINE TECHNIQUE DE L'INVENTION

La présente invention concerne en général les transistors de type métal oxyde semi-conducteur à effet de champs (MOSFET) et plus particulièrement la réduction d'éléments parasites limitant la vitesse de fonctionnement et augmentant la consommation des transistors.

### ÉTAT DE LA TECHNIQUE

La vitesse de commutation maximale d'un transistor MOSFET ( métal-oxyde-semiconducteur field effect transistor) dépend de la vitesse avec laquelle on peut effectivement établir et faire disparaître le courant de conduction. Elle dépend, entre autres, de nombreux paramètres physiques propres aux matériaux utilisés comme, par exemple, la mobilité des porteurs du matériau semi-conducteur employé et les niveaux et type de dopage des différentes zones définissant les électrodes. La vitesse de commutation dépend aussi largement de la géométrie et de la structure des transistors. Notamment, par l'intermédiaire des éléments parasites qui sont inévitablement introduits par la réalisation pratique de ces dispositifs. Deux éléments parasites particulièrement critiques sont, d'une part, la résistance série d'accès des électrodes source et drain, et la capacité parasite entre grille et source ou drain d'autre part. Ces éléments parasites forment une constante de temps qui contribue à limiter la vitesse de commutation maximale de tout transistor.

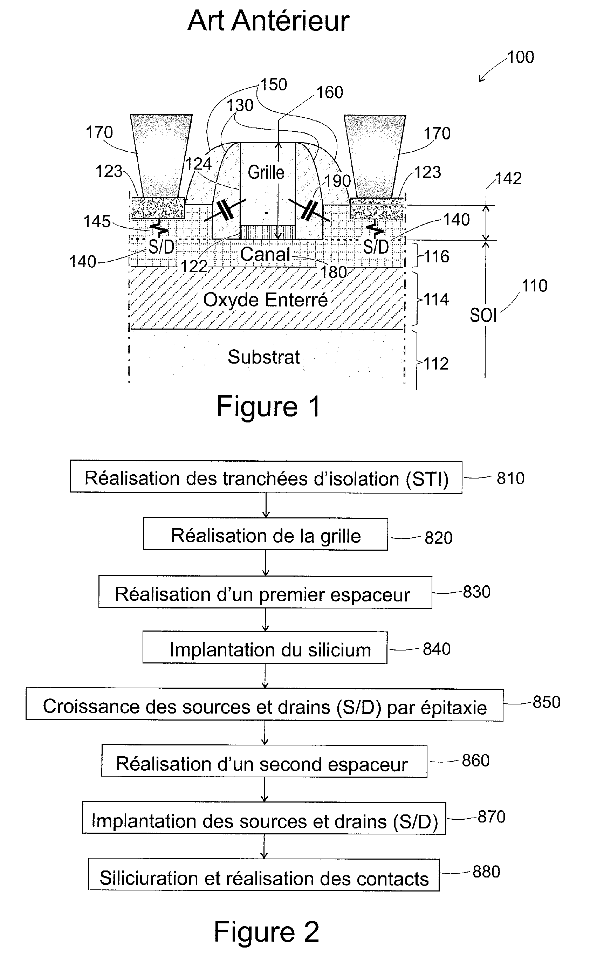

La **figure 1** montre une vue en coupe d'un transistor MOSFET 100 caractéristique de l'état actuel de la technique. De plus en plus de circuits intégrés sont actuellement réalisés à partir de substrats élaborés de type dit SOI, acronyme de l'anglais « silicon on insulator », c'est-à-dire «silicium sur isolant» et plus généralement « semi-conducteur sur isolant ». Dans la figure 1 on retrouve le substrat SOI 110 d'origine qui est constitué d'un substrat initial 112, le plus souvent une tranche homogène de silicium, et d'une couche d'oxyde enterrée 114 qui assure l'isolation des composants qui seront fabriqués dans la fine couche superficielle 116 de semi-conducteur présente sur la couche enterrée. La couche superficielle 116 est constituée le plus souvent du silicium monocristallin. L'isolation de chacun des transistors 100 est complétée par la réalisation de tranchées latérales d'isolation dites STI, acronyme de l'anglais « shallow trench isolation » c'est-à-dire « tranchées d'isolation peu profondes ». Elles atteignent la couche d'oxyde enterrée pour englober chacun des transistors dans une couche continue d'oxyde. Ces tranchées, qui ne sont pas nécessaires à la compréhension de l'invention, ne sont pas représentées.

La **figure 2** résume les principales étapes standard de fabrication d'un transistor MOSFET sur un substrat SOI représentatif de l'état de la technique. La première étape 810 consiste à réaliser, à partir du substrat SOI 110 d'origine, les tranchées d'isolation STI qui vont permettre d'assurer l'isolation complète de chacun des transistors 100. À l'étape globale suivante 820 on réalise l'empilement de couches et les motifs qui vont constituer l'empilement de grille 160 de chaque transistor comprenant deux couches essentielles : l'oxyde mince de grille 122 et la grille de commande 124. Cette dernière est faite de silicium polycristallin conducteur qui joue le rôle du métal dans la structure MOS du transistor ou d'un empilement de couches constitué d'un métal et de polysilicium. À l'étape suivante 830, on réalise une première couche d'espaceurs 130 sur les flancs de chaque motif de grille. Les espaceurs, faits de nitrure de silicium, et la grille elle-même, vont servir à protéger le canal 180 lors d'une première opération d'implantation de la couche superficielle de silicium qui va suivre. On notera ici que les espaceurs et les sources et drains sont réalisés sans mettre en oeuvre aucune opération de photolithographie. Comme mentionné ci-dessus une première implantation 840 des zones de source et drain 140 dans la couche superficielle 116, généralement faite de silicium monocristallin, est ensuite effectuée. Dans la description qui suit de l'invention les électrodes source et drain sont indifférenciées et référencées par un même acronyme « S/D » 140.

L'étape suivante 850 du procédé standard de réalisation d'un transistor conforme à la figure 1 consiste à accroître l'épaisseur 142 des zones source et drain (S/D). Opération dont le but principal est de réduire les résistances 145 d'accès de ces électrodes. L'épaississement des zones S/D se fait classiquement par croissance épitaxiale à partir de la couche sous jacente, c'est-à-dire la couche 116 de silicium monocristallin du substrat SOI d'origine. Il s'agit donc de diminuer l'un des éléments parasites mentionnés précédemment qui viennent limiter la vitesse de commutation et les performances des transistors. Comme on constate que la résistance d'accès est inversement proportionnelle à l'épaisseur des S/D on notera ici qu'il y a tout intérêt pour réduire significativement cet élément parasite à augmenter la surélévation des S/D. Ce type de transistor et de procédé est souvent qualifié de « RSD », acronyme de l'anglais « raised source drain » c'est-à-dire « source drain surélevés ».

Les autres opérations standard consistent en une étape 860 de réalisation d'une seconde couche d'espaceurs 150. Cette seconde couche d'espaceurs sert à limiter latéralement, autour du motif de grille, les zones de siliciuration qui permettent d'assurer un bon contact électrique avec le silicium des S/D 140 surélevés. La siliciuration 123 et les contacts métalliques 170 sont formés à l'étape 880. Préalablement, à l'étape 870, une seconde implantation des S/D est réalisée qui assure un dopage de ces zones. Comme pour les S/D on notera qu'une siliciuration de la partie haute de l'empilement de grille 160 faite de silicium polycristallin est également réalisée pour qu'on puisse aussi établir un bon contact électrique sur cette électrode. Par souci de clarté le contact de grille et sa zone siliciurée ne sont cependant pas représentés sur la figure 1.

L'autre élément parasite mentionné précédemment est la capacité 190 entre les S/D et la grille. Les espaceurs constituent le diélectrique de cette capacité. La capacité parasite due aux espaceurs tend à augmenter proportionnellement à l'accroissement d'épaisseur 142 de la couche épitaxiale de surélévation des S/D 140. On constate ainsi que dans le procédé standard de réalisation des MOSFET qui vient d'être brièvement décrit, les conditions d'optimisation des éléments parasites principaux qui limitent leur vitesse de commutation sont parfaitement antagonistes puisque que pour diminuer l'un, la résistance d'accès des source et drain 140, il faut augmenter la surélévation de ces derniers ce qui entraîne une augmentation de l'autre élément parasite, c'est-à-dire la capacité 190 entre la grille et les S/D 140.

Pour compenser l'augmentation de la capacité parasite entre la grille et les S/D 140, différentes techniques ont été proposées. Une première méthode consiste à utiliser des espaceurs dont le matériau est à plus faible permittivité que celui du nitrure de silicium actuellement utilisé. Par exemple, le remplacement du nitrure par de l'oxyde de silicium permet de réduire significativement la valeur de la capacité parasite.

Le remplacement du nitrure complique cependant sérieusement le procédé standard de fabrication des transistors MOSFET. Ce remplacement peut être obtenu en prévoyant des étapes supplémentaires au cours desquelles on retire finalement le nitrure qui a servi normalement de protection pour permettre l'auto alignement des S/D sur la grille comme expliqué précédemment. Le nitrure est alors remplacé, dans le dispositif final, par de l'oxyde de silicium avec l'avantage d'une diminution de la capacité parasite 190. Cette solution a donc pour inconvénient de rajouter au procédé standard des étapes additionnelles et délicates.

Le procédé standard peut aussi être modifié en prévoyant d'utiliser directement des espaceurs en oxyde de silicium. Ce matériau se prête cependant beaucoup moins bien que le nitrure à la réalisation des espaceurs et il n'existe pas actuellement de procédé industriellement fiable qui permette un remplacement direct du nitrure.

Une autre méthode qui a été expérimentée consiste en ce que la croissance épitaxiale qui permet l'obtention d'une source et d'un drain surélevés afin de diminuer la résistance d'accès de ces électrodes, soit réalisée en limitant la croissance latérale de cette épitaxie afin d'éloigner zones S/D 140 de la grille et donc de diminuer une capacité parasite 190 en augmentant l'épaisseur de diélectrique entre ces zones. Cette technique dite « épitaxie facettée » est cependant particulièrement difficile à maîtrisée. L'épaisseur de silicium déposée lors de la croissance d'une épitaxie facettée est très sensible à l'environnement. Ainsi, il y a des disparités d'épaisseur entre dispositifs larges et étroits qui peuvent induire des dysfonctionnements comme une siliciuration totale et l'apparition de courants de fuite qui nuisent gravement à la fiabilité des dispositifs. On constate également des disparités d'épaisseur entre les zones où la densité de motifs est grande et celles où elle est faible.

De cette brève présentation des procédés connus de réalisation des transistors MOSFET, il ressort qu'il n'existe pas de procédés simples et fiables qui permettent de réduire à la fois la résistance d'accès des électrodes source et drain et à la fois la capacité parasite entre ces électrodes et la grille de commande.

La présente invention a pour objectif de proposer une solution qui réponde à certaines au moins de ces contraintes. Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

La présente invention a pour objet un procédé de fabrication d'un transistor comprenant la formation d'un empilement de couches de type semi-conducteur-sur-isolant comportant au moins un substrat, également désigné substrat massif ou bulk substrat en anglais, surmonté d'une première couche isolante également désignée couche isolante initiale et d'une couche active destinée à former un canal pour le transistor, le procédé comprenant en outre la formation d'un empilement de grille sur la couche active et la réalisation d'une source et d'un drain. La réalisation de la source et du drain comprend au moins les étapes suivantes:
- la formation de part et d'autre de l'empilement de grille de cavités obtenues par au moins une étape de gravure de la couche active, de la première couche isolante sélectivement à l'empilement de grille au moins de manière à retirer la couche active, la couche isolante initiale en dehors de zones situées en dessous de l'empilement de grille;
- la formation d'une deuxième couche isolante, également désignée couche isolante reformée, comprenant la formation d'un film isolant sur les surfaces du substrat mises à nu par ladite gravure et sur les surfaces éventuellement laissées à nu de la couche active, de manière à ce que ledit film isolant forme avec la première couche initiale restante après gravure une couche isolante continue d'une cavité à l'autre du transistor; ainsi la couche isolante continue recouvre toutes les parois des cavités ;

La formation de ce film isolant est significativement plus aisée et précise qu'une implantation d'oxygène dans l'épaisseur d'une couche et à différentes profondeurs. En effet, il est difficile de contrôler avec précision la profondeur d'une implantation.

En outre, l'oxydation peut être réalisée sur toute la plaque, sans lithographie préalable, permettant ainsi d'augmenter la fiabilité et la précision du procédé.
- le remplissage des cavités par un matériau semi-conducteur de manière à former la source et le drain, le remplissage étant effectué de préférence par au moins une épitaxie et après éventuellement une étape de mise à nu des extrémités latérales du canal.

L'invention propose ainsi un procédé particulièrement simple pour former des source et drain enterrés en partie au moins sous le canal, en gravant des cavités au-delà de la couche isolante initiale d'un substrat semi-conducteur sur isolant. Les ouvertures ainsi formées dans le substrat sont isolées électriquement des zones actives et les source et drain sont alors formés en contrebas de la grille.

A la fois la source et le drain s'étendent en grande partie au moins sous la couche active et dans la cavité creusée sous la couche isolante initiale. Ainsi, le transistor présente une structure très particulière dans laquelle la source et/ou le drain sont inversés par rapport aux structures connues, c'est-à-dire qu'ils sont enterrés sous le canal et sous la face supérieure de la couche d'isolante initiale sous jacente au canal. Cette structure permet de réduire la capacité parasite entre la grille et la source le drain. En outre elle permet d'épaissir la source et le drain selon une direction perpendiculaire au plan du substrat ce qui a pour effet de réduire la résistance d'accès des électrodes de la source et du drain.

De manière également avantageuse, l'invention permet de rendre indépendante la hauteur de la grille par rapport à la hauteur des source et drain, ce qui permet notamment de réduire la hauteur de la grille.

Un autre avantage significatif de la présente invention réside dans le fait que les cavités sont formées dans la couche active et dans le canal par gravure sélective de la grille. Les cavités sont ainsi auto-alignées sur la grille. Les défauts d'alignement sont donc éliminés. Le procédé est particulièrement simple, fiable et aisément reproductible.

Un autre avantage significatif de la présente invention réside dans le fait que la hauteur des S/D est indépendante de l'épaisseur de la couche active formant le canal. Cet avantage est intéressant pour de très nombreuses applications et notamment pour les transistors dont le canal présente une très faible épaisseur tels que les transistors de type FDSOI (fully depeleted SOI) par exemple. En effet, l'invention permet de conserver un canal de très faible épaisseur tout en décidant librement de la hauteur de S/D, par exemple en l'augmentant dans le but de réduire la résistance d'accès des S/D sans pour autant augmenter la capacité parasite entre S/D et grille.

L'invention permet ainsi proposer ainsi une solution particulièrement efficace pour résoudre la problématique suivante : offrir une solution pour réduire la résistance d'accès des électrodes des S/D sans dégrader les performances du transistor, notamment en termes de vitesse.

La présente invention est particulièrement adaptée pour les substrats de type semi-conducteur sur isolant, tels que les substrats élaborés de type silicium-sur-isolant,(SOI) avec une couche enterrée d'oxyde (Buried Insulating Oxide, BOX) mince. Dans un cas avec une couche enterrée d'oxyde mince, on entend que l'épaisseur de la couche enterrée d'oxyde est comprise entre 145 et 5 nm (nanomètre), de préférence entre 25 et 5 nm sans que cela soit limitatif. L'avantage de l'invention est que les modes de réalisation ne dépendent pas de l'épaisseur de la couche enterré d'oxyde. Si une diminution de l'épaisseur de la couche enterrée d'oxyde est requise, par exemple pour assurer une meilleure électrostatique du transistor, l'invention demeure parfaitement applicable.

Un autre objet de la présente invention concerne un transistor comprenant un empilement de couches comprenant au moins et de préférence uniquement : une couche active destiné à former un canal pour le transistor, une couche isolante disposée en regard d'une face inférieure du canal et sur une face supérieure d'un substrat, un empilement de grille tournée au regard d'une face supérieure du canal et une source et un drain disposés de part et d'autre de l'empilement de grille et s'étendant au moins partiellement, de préférence principalement et encore plus préférentiellement entièrement, sous la face supérieure du canal et/ou sous l'empilement de grille. La source et le drain sont disposés dans des cavités situées de part et d'autre de l'empilement de grille. La couche isolante forme une couche ininterrompue entre les deux cavités du transistor. La couche isolante présente une face inférieure dont la distance par rapport à une face inférieure du substrat est plus importante sous l'empilement de grille que dans les cavités.

Cette structure de transistor possède l'avantage d'avoir des source et drain qui ne sont pas en regard avec la grille tout en ayant une épaisseur de la couche isolante aussi fine que désirée sous le canal et des source et drain isolés du substrat par une isolation diélectrique. Cela permet ainsi de réduire de manière particulièrement significative les capacités parasites entre la grille et des source et drain au minimum, et d'épaissir la source et le drain selon une direction perpendiculaire au plan du substrat ce qui a pour effet de réduire la résistance d'accès des électrodes de la source et du drain.

De manière préférée, la distance d1 entre une face inférieure de la couche isolante et une face inférieure du substrat mesurée sous l'empilement de grille est plus importante que la distance d2 entre la face inférieure de la couche isolante et la face inférieure du substrat mesurée au niveau d'une cavité.

De manière également avantageuse, cette structure peut présenter une couche isolante d'épaisseur sensiblement uniforme à la surface du substrat. A titre d'exemple non limitatif, l'épaisseur de la couche isolante est comprise entre 10 et 50 nm. Avantageusement cette épaisseur est faible, typiquement inférieure à 25 nm, tout en présentant une bonne homogénéité d'épaisseur. L'épaisseur est prise perpendiculairement au plan de la face inférieure du substrat.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1 montre une vue en coupe d'un transistor MOSFET caractéristique de l'état de la technique existant.
La FIGURE 2 résume les principales étapes standards de fabrication d'un transistor MOSFET représentatif de l'état de la technique.
La FIGURE 3 résume les principales étapes de fabrication d'un transistor selon le procédé de l'invention.
Les FIGURES 4a à 4e décrivent des étapes spécifiques du procédé de fabrication de transistors selon un premier mode de réalisation de l'invention, la figure 4e illustrant un exemple de transistor selon l'invention une fois finalisé.
Les FIGURES 5a à 5h décrivent des étapes spécifiques du procédé de fabrication de transistors selon un deuxième mode de réalisation de l'invention, la figure 5h illustrant un exemple de transistor selon l'invention une fois finalisé.
La FIGURE 6 résume les étapes de fabrication de transistors selon le deuxième mode de réalisation de l'invention.
Les FIGURES 7a à 7i décrivent des étapes spécifiques du procédé de fabrication de transistors selon un troisième mode de réalisation de l'invention, la figure 7i illustrant un exemple de transistor selon l'invention une fois finalisé.
La FIGURE 8 résume les étapes de fabrication de transistors selon le troisième mode de réalisation de l'invention.
Les FIGURES 9a à 9k décrivent des étapes spécifiques du procédé de fabrication de transistors selon un quatrième mode de réalisation de l'invention, la figure 9k illustrant un exemple de transistor selon l'invention une fois finalisé.
La FIGURE 10 résume les étapes de fabrication de transistors selon le quatrième mode de réalisation de l'invention.
Les FIGURES 11 a à 11 h décrivent des étapes spécifiques du procédé de fabrication de transistors selon un cinquième mode de réalisation de l'invention, la figure 11 h illustrant un exemple de transistor selon l'invention une fois finalisé.
La FIGURE 12 résume les étapes de fabrication de transistors selon le cinquième mode de réalisation de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatives de la réalité.

### DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement :

On rappelle tout d'abord que l'invention porte sur un procédé de fabrication d'un transistor comprenant la formation d'un empilement de couches de type semi-conducteur-sur-isolant comportant au moins un substrat, surmonté d'une couche isolante initiale (également désignée première couche) et d'une couche active destinée à former un canal pour le transistor, le procédé comprenant en outre la formation d'un empilement de grille sur la couche active et la réalisation d'une source et d'un drain. La réalisation de la source et du drain comprend au moins les étapes suivantes: la formation de part et d'autre de l'empilement de grille de cavités obtenues par au moins une étape de gravure de la couche active, de la couche isolante initiale et d'une partie de substrat sélectivement à l'empilement de grille au moins de manière à retirer la couche active, la couche isolante initiale et une portion du substrat en dehors de zones situées en dessous de l'empilement de grille ; la reformation d'une couche isolante (également désignée deuxième couche) comprenant la formation d'un film isolant sur les surfaces du substrat mises à nu par ladite gravure, de manière à ce que le film isolant forme avec la couche isolante initiale une couche isolante ininterrompue d'une cavité à l'autre du transistor; ainsi une couche isolante recouvre toutes les parois des cavités ; le remplissage des cavités par un matériau semi-conducteur de manière à former la source et le drain.

De manière préférée, la gravure de la couche active, de la couche isolante et du substrat est effectuée sur toute la surface de la couche active à l'exception des zones disposées sous l'empilement de grille et éventuellement à l'exception des zones disposées sous un ou des espaceurs optionnels recouvrant les flancs de l'empilement de grille et à l'exception des zones d'isolation par exemple de type STI (tranchée d'isolation peu profonde). Ces espaceurs sont considérés comme appartenant à l'empilement de grille.

De manière avantageuse, la reformation d'une couche isolante à la surface du substrat est effectuée par oxydation du substrat au moins à partir de sa surface. De préférence, l'oxydation est une oxydation thermique.

De manière préférée, le remplissage des cavités est effectué par épitaxie à partir des extrémités latérales du canal. Préalablement à l'épitaxie, les extrémités latérales du canal sont mises à nu.

De préférence, la couche isolante reformée est ininterrompue sur l'ensemble de la plaque ou tout au moins pour une pluralité de transistors. La couche isolante initiale demeure sous les grilles et la couche isolante additionnelle formant avec la couche isolante initiale une couche ininterrompue est présente sur les zones actives non recouvertes de grille.

De manière préférée, la couche isolante reformée est ininterrompue mais peut néanmoins présenter une inhomogénéité d'épaisseurs d'une cavité à l'autre. La reformation d'une couche isolante conserve la présence de cavités. L'oxydation du substrat forme un film isolant sur les surfaces du substrat mises à nu par la gravure. Ce film isolant est au contact de la portion de la couche isolante initiale qui est située sous l'empilement de grille et qui n'a donc pas disparu lors de la gravure. Le film isolant et les portions restantes de la couche isolante initiale forment une couche isolante ininterrompue d'une cavité à l'autre du transistor. Le film isolant est formé, typiquement par oxydation, dans le fond des cavités et éventuellement sur des parois verticales du substrat.

Selon un mode de réalisation préféré, la formation des cavités comprend également la gravure d'une épaisseur du substrat.

De manière avantageuse, les cavités présentent chacune un fond formé par le substrat et le remplissage des cavités est effectué depuis le canal vers le fond des cavités. Avantageusement, cela permet d'éviter que les régions de source et drain soient en regard de la grille.

Avantageusement, le remplissage est effectué de manière à ce que les zones de sources et drain s'étendent exclusivement dans un plan situé en dessous de la grille.

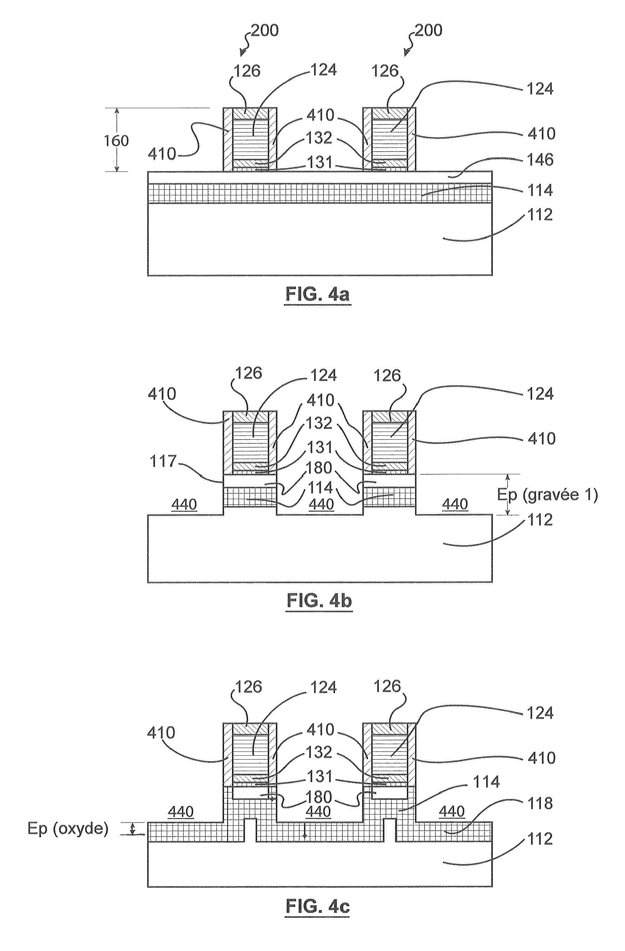

De manière préférée, le procédé comprend, après l'étape d'oxydation du substrat, une étape de gravure partielle de la couche isolante reformée par l'étape d'oxydation. Préférentiellement, l'épitaxie est effectuée de manière à ce que l'épaisseur des source et drain réalisés par épitaxie présentent chacun une dimension Ep(epi) sensiblement égale à Ep(gravée1) - 0,54.EP(oxyde) + Ep(gravée2), comme illustré en figures 4b à 4e, avec :
Ep(gravée1) correspond à l'épaisseur gravée lors de la formation des cavités ;
0,54.EP(oxyde) correspond à l'augmentation d'altitude associé à l'oxydation, soit la différence entre l'épaisseur du film isolant formé et l'épaisseur du semi-conducteur, typiquement du silicium, consommé pour fabriquer ce film isolant.
Ep(gravée2) correspond à l'épaisseur gravée lors de l'étape de gravure partielle de la couche isolante reformée.
De préférence, Ep(epi) < 1,3 . Ep(gravée1) - 0,54.EP(oxyde) + Ep(gravée2).
De préférence, Ep(epi) > 0,8 . Ep(gravée1) - 0,54.EP(oxyde) + Ep(gravée2).
De préférence, Ep(epi) = Ep(gravée1) - 0,54.EP(oxyde) + Ep(gravée2).

De préférence, l'étape de formation d'une cavité dans la couche isolante initiale et le substrat est réalisée de sorte à former une cavité dont la profondeur est à choisir en fonction de la dimension des source et drain définis par épitaxie, de manière à éviter la formation des vides sous l'épitaxie et en tenant compte de considérations de performance électrique telles que le dimensionnement des résistances d'accès par rapport aux spécifications. Plus la cavité sera profonde, plus on augmente les chances de former un vide. De préférence, pour former ladite cavité, une gravure anisotrope ou isotrope est réalisée.

Selon un mode de réalisation, la formation d'une deuxième couche isolante comprend la formation par oxydation du substrat d'un film isolant sur toutes les surfaces à nu du substrat et de la couche active située en dessous de l'empilement de grille de manière à ce que le film isolant forme avec la première couche isolante une couche isolante continue d'une cavité à l'autre du transistor.

Selon certains modes de réalisation, l'étape de reformation d'une couche isolante par oxydation du substrat comprend l'oxydation des extrémités latérales du canal.

De préférence ; l'étape d'oxydation est effectuée de manière à ce que la largeur oxydée des extrémités du canal soit inférieure à l'épaisseur oxydée du substrat. La largeur est prise selon une direction parallèle au plan de la face inférieure du substrat. L'épaisseur est prise selon une direction perpendiculaire au plan de la face inférieure du substrat.

De manière préférée, l'étape d'oxydation est effectuée de manière à ce que l'épaisseur du substrat oxydé soit au moins deux fois supérieure à la largeur oxydée des extrémités latérales du canal.

De manière avantageuse, le procédé comprend, après l'étape d'oxydation, une étape de gravure partielle isotrope de la couche isolante reformée par l'étape d'oxydation, la gravure partielle étant réalisée de manière à mettre à nu les extrémités latérales du canal et à ce que la couche isolante reformée demeure ininterrompue d'une cavité à l'autre du transistor.

Ainsi, selon ces modes de réalisation, la mise à nu des extrémités latérales du canal s'effectue par gravure des portions du canal qui ont été oxydées.

De préférence, la gravure partielle est une gravure isotrope sèche ou humide. De préférence, la gravure est une gravure à l'acide fluorhydrique ou dans un plasma fluoré.

De préférence, la gravure partielle est arrêtée lorsque la largeur oxydée des extrémités du canal est consommée. De préférence, l'arrêt se fait en calculant le temps nécessaire à la consommation de la largeur oxydée des extrémités latérales du canal par la solution de gravure. Une couche oxydée reste donc en place sur le substrat. La continuité de la couche isolante reformée est donc préservée.

De préférence, le procédé comprend, préalablement à l'étape de formation des cavités, une étape de formation d'au moins une couche de protection formant un espaceur et disposée sur des flancs de la grille, la gravure partielle de la couche isolante reformée étant sélective de ladite couche de protection de manière à ce qu'après l'étape de gravure partielle les extrémités latérales du canal soient en retrait par rapport à la couche de protection.

Avantageusement, la couche de protection est formée avant l'étape de gravure de la couche isolante reformée. Ainsi, le retrait de la couche d'oxyde sur les extrémités latérales du canal fait que les extrémités latérales du canal sont en retrait par rapport à la couche de protection. Cette dernière présente une paroi qui surplombe les extrémités latérales du canal. La face inférieure de la couche de protection, sensiblement parallèle au plan du substrat, empêche une croissance par épitaxie vers la grille amorcée à partir du canal. La couche de protection tend donc à diriger l'épitaxie vers le fond des cavités et vers le substrat, c'est-à-dire vers le bas et non pas vers la grille, c'est-à-dire vers le haut.

De préférence, la couche de protection est disposée au contact des flancs de la grille.

De manière avantageuse, l'étape d'oxydation est effectuée de manière à ce que la largeur oxydée des extrémités latérales du canal soit inférieure ou égale à la largeur de la couche de protection disposée sur les flancs de la grille.

Avantageusement, le procédé comprend une étape de dopage in situ des source et drain formés par épitaxie dans les cavités.

Selon une variante de réalisation particulièrement avantageuse, l'étape de reformation d'une couche isolante comprend une étape d'oxydation thermique du substrat préférentiellement au canal. De manière préférée, le substrat présente un dopage supérieur à la couche active et le dopage du substrat favorise l'oxydation du substrat par rapport à l'oxydation du canal. Avantageusement, on prévoit un dopage de type N à l'arsenic (As), P ou B avec un niveau de dopage de 1^{E}19 at/cm³ à quelque 1^{E}20 at/cm³. De manière plus générale, on privilégie un niveau de dopage élevé, voire proche de la limite de la solubilité du matériau formant le substrat.

On pourra par exemple se référer aux publications suivantes :
- Formation of As enriched layer by steam oxidation of As+-implanted Si - A. Baghizadeh, D. Agha-Aligol, D. Fathy, M. Lamehi-Rachti, M. Moradi parue dans Applied Surface Science 255 (2009) 5857-5860.
   - Oxide Growth Enhancement on Highly n-Type Doped Silicon under Steam Oxidation-Erich Biermann, Horst H. Berger, Peter Linke, and Bernt Muller - Institute of Microelectronics, Technical University Berlin, D-1 0623 Berlin, Germany - parue dans J. Electrochem. Soc., Vol. 143, No. 4, April 1996 The Electrochemical Society, Inc.
   - Thermal Oxidation of Heavily Doped Silicon B. E. Deal and M. SklarResearch & Development Laboratory, Fairchild Semiconductor, Pale Alto, California, ECS Vol. 112, No. 4.

Selon une autre variante de réalisation particulièrement avantageuse, l'étape de reformation d'une couche isolante comprend les étapes suivantes :
après la formation des cavités, une étape de formation d'au moins une couche de protection sacrificielle masquant les flancs de l'empilement de grille, les extrémités latérales du canal et des flancs de la couche isolante initiale et des flancs du substrat mis à nu par la formation des cavités si la gravure a attaqué le substrat, la couche de protection sacrificielle laissant à nu le substrat dans le fond des cavités. La couche de protection sacrificielle s'étendant verticalement et formant un espaceur pour la grille. La couche de protection sacrificielle laisse à nu le fond des cavités formé par le substrat, la couche de protection sacrificielle étant choisie de manière à isoler au moins le canal d'une porosification électrolytique ;
   - une étape de porosification électrolytique du substrat, de préférence par acide fluorhydrique,
   - une étape de mise à nu des extrémités latérales du canal par retrait de la couche de protection sacrificielle,
   - une étape d'oxydation thermique du substrat préférentiellement au canal.

La cinétique d'oxydation du substrat rendu poreux est significativement supérieure à celle du matériau constituant le canal. L'épaisseur oxydée du substrat est donc supérieure à la largeur oxydée du canal.

De préférence le procédé comprend, préalablement à l'étape de porosification, une étape de dopage du substrat.

De préférence, le procédé comprend, préalablement à l'étape de reformation d'une couche isolante, une étape de formation d'une couche de protection sacrificielle disposée de manière à protéger au moins les extrémités latérales du canal et comprenant, avant l'étape de remplissage des cavités, une étape de retrait de la couche de protection sacrificielle pour mettre à nu les extrémités latérales du canal. Ainsi, selon ces modes de réalisation, la mise à nu des extrémités latérales du canal s'effectue par retrait de la couche de protection sacrificielle.

De manière avantageuse, la reformation d'une couche isolante comprend une étape d'oxydation du substrat et la couche de protection sacrificielle protège empêche l'oxydation du canal lors de cette étape d'oxydation. La couche de protection s'étend verticalement. Elle recouvre les flancs de la grille et les flancs du canal.

Avantageusement, la formation des cavités comprend une étape de gravure de la couche active sélective de l'empilement de grille avec arrêt de gravure à la surface de la couche isolante initiale et une étape de gravure de la couche isolante initiale avec arrêt sur ou dans le substrat. L'étape de formation de la couche de protection sacrificielle est effectuée après ladite étape de gravure de la couche active et avant ladite étape de gravure de la couche isolante initiale.

De manière avantageuse, l'étape d'oxydation est effectuée de manière à ce que l'épaisseur du substrat oxydé soit au moins deux fois supérieure à la largeur de la couche de protection sacrificielle.

De préférence, le substrat est en un matériau semi-conducteur non dopé. Selon une alternative, le substrat est en un matériau semi-conducteur dopé. Ainsi, ces modes de réalisation permettent l'utilisation d'un substrat dopé ou non ce qui offre une grande liberté de procédé et de structures finales.

Avantageusement, le procédé comprend, après l'étape d'oxydation pour reformer une couche isolante, une étape de gravure partielle de la couche isolante reformée.

De manière avantageuse, l'étape de gravure partielle de la couche isolante reformée est une gravure isotrope et l'épaisseur gravée est au moins égale à la largeur de la couche de protection sacrificielle.

Selon un mode de réalisation, l'étape de retrait de la couche de protection sacrificielle est effectuée avant ladite étape de gravure partielle de la couche isolante reformée. Un procédé de gravure de l'oxyde sélectif au silicium, typiquement à base d'acide fluorhydrique, est réalisé. Le canal n'est donc pas impacté par la gravure.

Selon d'autres modes de réalisation, l'étape de retrait de la couche de protection sacrificielle est effectuée après ladite étape de gravure partielle de la couche isolante reformée.

De préférence, l'étape de retrait de la couche de protection sacrificielle est effectuée avant l'étape de remplissage des cavités, le procédé comprenant en outre, après l'étape de remplissage des cavités, une étape de formation d'au moins un espaceur de part et d'autre de l'empilement de grille et au contact de l'empilement de grille. La grille est ainsi encapsulée entre l'espaceur et le masque dur.

Selon une option, la couche de protection sacrificielle est disposée directement au contact des flancs de l'empilement de grille. Ainsi le retrait de la couche de protection sacrificielle met à nu les flancs de l'empilement de grille. De préférence, les flancs de la grille sont à nu au début de l'étape de remplissage, les structures cristallines de la grille et du canal sont différentes et l'étape de remplissage des cavités comprend une pluralité de cycles comprenant chacun : une épitaxie amorcée à partir du canal et à partir des flancs de la grille ; une gravure d'un matériau en croissance épitaxiale à partir des flancs de la grille sélectivement à matériau en croissance épitaxiale à partir du canal.

Selon une autre option, l'étape de formation de la couche de protection sacrificielle, une étape de protection des flancs de la grille comprenant une oxydation des flancs de la grille, les flancs de la grille conservant une couche oxydée lors de l'étape de remplissage des cavités. Avantageusement, le remplissage des cavités est préférentiellement effectué par épitaxie, la couche d'oxyde formée sur les flancs de la grille empêche toute épitaxie à partir de la grille.

De préférence, la formation de l'empilement de grille comprend une étape de formation d'un masque dur sur une grille en matériau semi-conducteur. L'étape de protection des flancs de la grille comprend après formation de l'empilement de grille et avant gravure de la couche active, une étape d'oxydation thermique des flancs de la grille et d'une portion de la couche active, une étape de gravure anisotrope de l'oxyde formé lors de l'étape de protection des flancs de la grille sélectivement au masque dur de manière à retirer la couche d'oxyde sur la couche active et à conserver une couche d'oxyde au droit du masque dur sur les flancs de la grille. La gravure anisotrope est dirigée dans une direction perpendiculaire au plan du substrat. La couche oxydée du flanc de grille est protégée par le masque dur.

De préférence, le procédé comprend, après l'étape de gravure anisotrope pour conserver une couche d'oxyde sur les flancs de la grille, une étape de gravure anisotrope de la couche active avec arrêt sur la couche isolante initiale pour retirer la couche active de part et d'autre de l'empilement de grille de manière à mettre à nu les extrémités latérales du canal, puis l'étape de formation de la couche de protection sacrificielle est effectuée de manière à protéger les extrémités latérales du canal lors de la gravure de la couche isolante initiale pour former les cavités et lors de l'étape de reformation d'une couche isolante.

Avantageusement, l'épaisseur d'oxyde formé est supérieure ou égale à la largeur de la couche de protection sacrificielle. De préférence l'épaisseur oxydée est comprise entre 1 et 5 nm. De préférence l'oxydation est isotrope, la largeur oxydée des flancs de grille étant égale à la profondeur oxydée de la couche active.

De préférence, l'empilement de grille comprend les couches suivantes empilées depuis la couche active : une couche isolante (par exemple une couche high-k), une couche métallique, la grille et un masque dur recouvrant la surface supérieure de la grille.

Selon un mode de réalisation, l'étape de formation des espaceurs de protection est effectuée après la gravure du canal. Selon un autre mode de réalisation, l'étape de formation des espaceurs de protection est effectuée avant la gravure du canal.

De préférence, la couche isolante initiale est une couche d'oxyde enterrée d'un empilement de couches de type SOI.

Avantageusement, la couche active est une couche de matériau semi-conducteur à base de silicium ou de germanium. Elle peut par exemple être en silicium, en germanium ou en silicium-germanium.

Selon un mode de réalisation avantageux, la couche active est une couche de matériau semi-conducteur monocristallin, tel que le silicium monocristallin.

Selon un mode de réalisation au niveau des cavités, la face supérieure du film isolant se situe en dessous de la face inférieure de la couche active formant le canal. Cela permet notamment de réduire la résistance d'accès aux S/D sans augmenter la capacité parasite entre S/D et grille.

Selon un mode de réalisation au niveau des cavités, la face supérieure du film isolant se situe en dessous de la face inférieure de la couche isolante initiale de l'empilement SOI.

Un autre objet de la présente invention concerne un transistor comprenant un empilement de couches comprenant au moins et de préférence uniquement : une couche active formant un canal pour le transistor, une couche isolante disposée au regard d'une face inférieure du canal et sur une face supérieure d'un substrat, un empilement de grille tournée au regard d'une face supérieure du canal et une source et un drain disposés de part et d'autre de l'empilement de grille et s'étendant au moins partiellement, de préférence principalement et encore plus préférentiellement entièrement, sous la face supérieure du canal et/ou sous l'empilement de grille. La source et le drain sont disposés dans des cavités situées de part et d'autre de l'empilement de grille. La couche isolante forme une couche ininterrompue entre les deux cavités du transistor. La couche isolante présente une face inférieure dont la distance par rapport à une face inférieure du substrat est plus importante sous l'empilement de grille que dans les cavités.

La distance est prise selon une direction perpendiculaire à la face inférieure du substrat et à partir de cette face.

Ainsi, la couche isolante forme une marche sous l'empilement de grille. Sous l'empilement de grille, le substrat remonte au-delà de la hauteur de la face inférieure de la couche isolante reformée prise dans une cavité. Ainsi, uniquement sous l'empilement de grille, le substrat forme un relief en saillie dont les faces sont au contact de la couche isolante. Ainsi, la face inférieure de la couche isolante et la face supérieure du substrat ne sont pas planes

L'empilement de grille comprend une grille de commande et les zones de source et drain s'étendent en partie au moins et de préférence complètement sous la grille de commande. Ainsi, ils sont enterrés sous la grille de commande. Avantageusement, ils s'étendent sur au moins 50% et préférence sur au moins 70% de leur hauteur sous la grille de commande. De préférence, ils s'étendent sur au moins 90% de leur hauteur sous la grille de commande. Selon un mode de réalisation non limitatif, la source et le drain présentent chacun une portion au regard de la grille selon une direction parallèle au plan du substrat, la hauteur de ladite portion selon une direction perpendiculaire au plan du substrat est inférieure à 0.3 fois la hauteur de la grille. De préférence cette hauteur est inférieure à 0.1 fois la hauteur de la grille.

Il est précisé que dans le cadre de la présente invention, le terme « sur » « surmonte » ou « sous jacent » ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

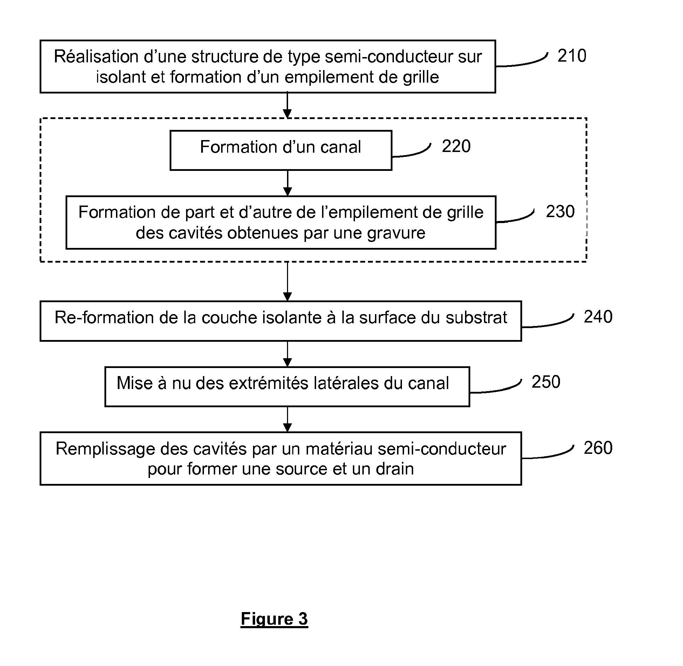

La **figure 3** résume les principales étapes de fabrication d'un transistor selon un mode de réalisation de l'invention.

La structure de départ du procédé selon l'invention est une structure de type semi-conducteur sur isolant, par exemple de type SOI (silicium sur isolant), sur lequel est formée une grille de commande du transistor. Cette étape est référencée 210 sur la figure 3. Une ou plusieurs étapes (220, 230) consistent à former, de part et d'autre de la grille 124, des cavités 440 à travers la couche active 146, la couche isolante de la structure SOI également désignée couche isolante initiale 114, voire dans une portion du substrat 112. Avantageusement, ces cavités 440 sont obtenues par une ou des gravures sélectives de l'empilement de grille 160. Les surfaces des cavités 440 sont ensuite rendues isolantes pour former une couche isolante 118 continue. La couche 118 est ininterrompue (étape 240). Il apparaît sur les figures 4a à 11h qu'elle est ininterrompue entre les deux transistors représentés sur ces figures. Des extrémités latérales du canal sont alors mises à nu (étape 250). Les source et drain 140 sont ensuite réalisés en remplissant les cavités 440 avec un matériau semi-conducteur (étape 260). Avantageusement, les cavités 440 sont remplies par épitaxie à partir des extrémités latérales 117 mises à nu du canal 180.

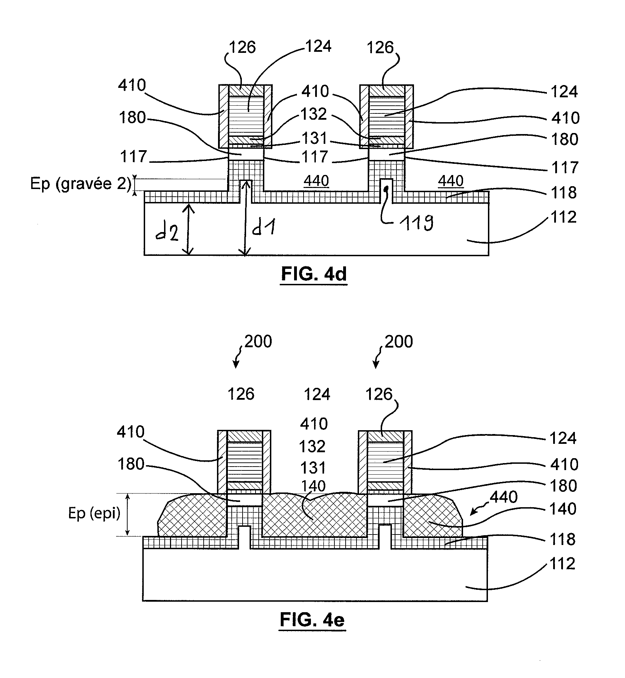

Ces étapes seront décrites avec plus de détails en référence aux différents modes de réalisation illustrés en figures 4 à 11.

Les **figures 4a à 4e** décrivent des étapes d'un premier mode de réalisation selon le procédé de l'invention.

La figure 4a illustre une structure 200 de type SOI dont la couche active 146 est surmontée de deux grilles 124. Seules deux grilles 124 sont illustrées sur cette figure pour faciliter la compréhension de l'invention. Cette figure est obtenue à l'issue de l'étape 210 de la figure 3. Cette étape 210 consiste à réaliser, à partir d'un substrat 112, souvent désigné substrat massif (bulk substrat en anglais), une couche isolante initiale 114 et une couche active 146 destinée à former ultérieurement le canal 180 de chaque transistor 200. Ensuite, au cours de cette étape 210, un empilement 160 comportant des couches suivantes empilées depuis la couche active 146 est réalisé : une couche d'isolation de la grille, souvent désignée oxyde mince de grille 131 ou couche high-k, une couche métallique 132, une grille 124 et un masque dur 126 recouvrant la surface supérieure de la grille 124. En outre, le substrat 112 est préférentiellement un substrat dopé dont le niveau de dopage est élevé, afin de pouvoir oxyder préférentiellement le substrat 112 dans une étape ultérieure.

Dans la suite de la description on qualifie d'empilement de grille l'empilement 160 de couches comprenant au moins la grille 124 et la couche d'isolation 131. L'empilement 160 peut également comprendre, de manière optionnelle, la couche 132, la couche 126 et/ou une couche de contact électrique sur le sommet de la grille 124, souvent formée par siliciuration de la grille 124 et destinée à assurer un bon contact électrique entre la grille 124 et les autres éléments du dispositif.

De manière avantageuse, ce mode de réalisation prévoit également la réalisation de couches de protection également désignées espaceurs 410 situées de part et d'autre de l'empilement de grille 160. Ces espaceurs 410 recouvrent les flancs de l'empilement 160. Ils sont avantageusement faits de nitrure de silicium. Le masque dur 126 et les espaceurs 410 protègent l'empilement 160 pour que les flancs de l'empilement 160 ne soient pas gravés lors des opérations qui vont suivre. Comme cela apparaîtra dans la suite de la description, le masque dur 126 et les espaceurs 410 sont faits d'un matériau résistant aux produits de gravure des cavités, par exemple en nitrure de silicium.

La figure 4b illustre la structure obtenue à l'issue de l'étape 220 et de l'étape 230. Selon le premier mode de réalisation, la formation du canal 180 (étape 220) et la formation des cavités 440 (étape 230) de part et d'autre de l'empilement de grille 160 sont réalisées par une seule gravure anisotrope sélective par rapport au masque dur 126 de la grille 124. Cette gravure anisotrope a pour direction privilégiée de gravure une direction perpendiculaire au plan du substrat 112. De préférence, cette gravure est parfaitement anisotrope dirigée verticalement.

A ce stade, comme mentionné précédemment, la présence du masque dur 126 et des espaceurs 410 sert de protection à l'empilement de grille 160. La gravure retire donc les portions de couche active 146 et de couche isolante initiale 114 qui ne sont pas situées en dessous de la grille 124. Les cavités 440 sont formées par une gravure qui attaque préférentiellement les surfaces horizontales de la couche active 146, de la couche isolante initiale 114 et de préférence d'une partie supérieure du substrat 112, c'est-à-dire celles qui sont parallèles au plan du substrat 112, la gravure ne laissant en place que les surfaces perpendiculaires couvrant les flancs des motifs de l'empilement de grille 160. Le canal 180 est ainsi défini.

La ou les gravures sont effectuées de manière à attaquer toute la surface de la couche active 146 non protégée par l'empilement de grille 160 et toute la surface de la couche isolante initiale 114 non protégée par l'empilement de grille 160.

De manière particulièrement avantageuse les cavités 440 ainsi formées par gravure sont automatiquement alignées par rapport à l'empilement de grille 160.

La ou les gravures permettent de retirer en totalité la couche active 146 et la couche isolante initiale 114 non protégée par l'empilement de grille 160. De préférence, la gravure retire également une portion du substrat massif 112.

La profondeur de gravure est à choisir en fonction de la dimension d'une source et d'un drain 140 souhaités et de l'épaisseur de la couche isolante. On peut prévoir d'arrêter la gravure lorsque toute l'épaisseur de la couche isolante 114 est retirée. On peut également prévoir de graver le substrat comme représenté en figure 4b. Cela dépend essentiellement de l'épaisseur des S/D que l'on souhaite. De préférence, la profondeur gravée dans le substrat 112 est comprise entre 5 et 50 nm.

On veillera également à ce que la profondeur ne soit pas trop importante afin d'éviter la formation de vide entre le substrat 112 et les zones de source et drain 140 à former. Cet aspect sera précisé dans la suite de la description.

On notera ici que le canal 180 et les cavités 440 peuvent être obtenues en répétant l'étape 230 de gravure jusqu'à obtenir une profondeur des cavités 440 préférée. De plus, dans d'autres modes de réalisation, l'étape 220 et l'étape 230 peuvent être réalisées séparément. On peut ainsi effectuer une première gravure pour retirer la couche active 146 puis effectuer une ou plusieurs autres gravures pour retirer la couche isolante initiale 114 et éventuellement une portion du substrat 112.

La figure 4c montre la structure obtenue à l'issue de l'étape 240 de formation ou de reformation d'une couche isolante à la surface du substrat 112. La couche isolante 118 comprend les portions de la couche isolante initiale 114 non gravées (ces portions étant situées sous l'empilement de grille 160 et sous le canal 180, elles sont donc protégées lors de la gravure) et les zones du substrat 112 où la surface a été rendue isolante.

Cette étape de formation de la couche isolante 118 est de préférence effectuée en oxydant la surface mise à nu du substrat 112 par la formation des cavités.

L'oxydation du substrat 112 forme un film isolant sur les surfaces mises à nu du substrat 112 par la gravure. Ce film isolant est au contact de la portion de la couche 114 qui est située sous l'empilement de grille 160 et qui n'a donc pas disparu lors de la gravure. Le film isolant et les portions restantes de la couche 114 définissent une couche isolante reformée 118 ininterrompue d'une cavité 440 à l'autre du transistor 200. Elle peut par exemple s'étendre sur toute la plaque ou entre des tranchées d'isolation de type STI.

L'oxydation de la surface du substrat 112 pour former le film isolant conduit également, dans ce mode de réalisation non limitatif, à oxyder les portions du canal 180 qui ne sont pas protégées. En effet, le canal 180 n'est pas protégé par les espaceurs 410 ou par des couches de protection, comme cela est par exemple le cas du troisième mode de réalisation décrit ci-dessous. Avantageusement, on effectue l'oxydation de manière à ce que la largeur de la couche d'oxyde formée sur les extrémités du canal 180 soit au maximum égale à la largeur des espaceurs 410. Par exemple les espaceurs présentent une largeur de 10 nm. En outre, on effectue l'oxydation de manière à ce que l'épaisseur de la couche oxydée formée à la surface du substrat 112 est au moins deux fois plus importante que la largeur de la couche d'oxyde formée sur les extrémités du canal 180. Pour la longueur de grille du noeud technologique considéré, telles que la longueur de 14 nm ou 20 nm, la formation d'un oxyde aussi fin que 1 nm au niveau du canal est réalisable.

Dans le cadre de la présente invention on qualifie de largeur une dimension prise selon une direction parallèle au plan de la face inférieure du substrat 112. On qualifie d'épaisseur une dimension prise selon une direction perpendiculaire au plan de la face inférieure du substrat. Ainsi, sur les figures illustrées, les largeurs de la couche d'oxyde des extrémités du canal 180 et la largeur des espaceurs 410 sont prises selon une direction horizontale et les épaisseurs sont prises selon une direction verticale.

On qualifie d'extrémités latérales du canal 180 les extrémités 117 qui apparaissent dans le plan des figures. Ces extrémités sont indiquées en figures 4b et 4d sous la référence 117.

Ainsi, de manière avantageuse, l'oxydation s'effectue donc de manière privilégiée sur le substrat 112 plutôt que sur le canal 180.

Préférentiellement, pour obtenir une cinétique d'oxydation plus rapide sur le substrat 112 qu'au niveau du canal 180, on prévoit un niveau de dopage pour le substrat 112 différent du niveau de dopage du canal 180.

Avantageusement, on prévoit un dopage de type N à l'arsenic (As) avec un niveau de dopage de 10²⁰ /cm³. De manière plus générale, on privilégie un niveau de dopage élevé, voire proche de la limite de la solubilité du matériau formant le substrat 112.

De manière plus générale, le substrat 112 et de préférence sa surface uniquement, peut être dopé avec une espèce prise parmi As, B, P. Le niveau de dopage du substrat 112 est compris entre 1^{E}19 et quelque 1^{E}20 atomes par cm³. De manière plus avantageuse, il est supérieur à 1^{E}20 atomes par cm³.

Selon un mode de réalisation, le canal 180 peut ne pas être dopé lors de l'oxydation. Selon un mode de réalisation, le niveau de dopage du substrat 112 est de l'ordre de 1^{E}16 atomes par cm³.

A titre d'exemple, le substrat 112 est dopé N et le canal 180 est non dopé. Avantageusement, l'oxydation est une oxydation en phase vapeur à basse température, typiquement une température comprise entre 700 et 800°C. Ces conditions permettent d'avoir des cinétiques d'oxydation significativement différentes entre substrat 112 et canal 180.

Cette différenciation s'opère très bien pour de faibles épaisseurs d'oxydes (régime linéaire d'oxydation). L'épaisseur d'oxyde formée est inférieure à 100 nm.

Cette étape d'oxydation forme ainsi un film isolant sur toutes les surfaces à nu du substrat 112 et de la couche active 146. De préférence, cette oxydation est effectuée pleine plaque. Aucune lithographie préalable n'est nécessaire pour définir des zones spécifiques à oxyder ce qui rend le procédé plus précis et fiable.

La figure 4d montre la structure obtenue à l'issue de l'étape 250 de mise à nu des extrémités latérales 117 du canal 180.

Dans ce mode de réalisation illustré en figure 4, la reformation d'une couche isolante 118 conduit à recouvrir d'oxyde les extrémités latérales 117 du canal 180. L'étape 250 est alors réalisée pour mettre à nu les extrémités latérales 117 du canal 180. Le canal 180 sera alors prêt à servir de source de croissance épitaxiale lors de l'étape 260 de remplissage des cavités 440 comme cela sera décrit en référence à la figure 4e.

Afin de retirer la couche d'oxyde formée sur le canal 180, on réalise de préférence une gravure isotrope. Cette gravure est effectuée de manière à :
- totalement retirer l'oxyde au niveau du canal 180 afin de mettre à nu les extrémités latérales 117 du canal 180 ;
- partiellement retirer l'oxyde au niveau du substrat 112.

C'est pourquoi il est important que la largeur oxydée aux extrémités latérales 117 du canal 180 soit inférieure à l'épaisseur oxydée à la surface du substrat 112. Il reste donc une couche d'oxyde à la surface du substrat 112. Cette couche d'oxyde forme, avec la couche isolante initiale 114, une couche isolante 118 continue ou ininterrompue d'une cavité 440 à l'autre d'un même transistor 200. Notamment, l'oxyde est toujours présent en surface du substrat 112, c'est-à-dire sur ses parois planes et également sur ses parois verticales si les cavités 440 s'étendent dans le substrat 112.

La gravure est par exemple une gravure à l'acide fluorhydrique. On stoppe la gravure dès que l'oxyde sur les flancs du canal 180 a été consommé. La durée de gravure est déterminée par l'épaisseur d'oxyde formée précédemment au niveau du canal 180 et par la cinétique de gravure.

Pour déterminer le moment auquel la gravure doit être stoppée, on veille également à conserver suffisamment d'oxyde au niveau des tranchées d'isolation lorsqu'elles sont présentes (non représentées sur les figures).

La figure 4e montre la structure obtenue à l'issue de l'étape 260 de formation de la source et du drain 140. Cette étape consiste essentiellement à remplir les cavités 440 est avec un matériau semi-conducteur, par exemple du silicium pour former des régions de source et drain 140 pour chaque transistor 200.

De manière avantageuse, les cavités 440 sont remplies par une épitaxie amorcée par le matériau semi-conducteur du canal 180. De préférence, le canal 180 est un matériau semi-conducteur monocristallin et les zones de source et drain 140 sont également monocristalline.

On prévoit alors des matériaux identiques pour former le canal 180 et pour remplir les cavités 440. On peut par exemple utiliser du silicium ou d'autres matériaux semi-conducteurs aussi susceptibles d'être utilisés sous une forme monocristalline comme le germanium (Ge) ou des alliages de ces deux matériaux (Si-Ge). On peut également prévoir des matériaux différents mais existant sous une forme cristalline adaptée au réseau cristallin du canal 180, c'est-à-dire qu'il présente, par exemple, des paramètres de maille qui diffèrent de moins de 1 % et de préférence de moins de 0.5% de celui du matériau du canal 180 dans le plan parallèle à la face du substrat 112.

Ces caractéristiques relatives à l'étape 260 de remplissage des cavités 440 sont valables pour tous les modes de réalisation suivants qui font intervenir une épitaxie pour remplir les cavités 440.

Il convient de noter que l'épitaxie se fait vers le bas pour remplir les cavités 440 et éviter que les zones de source et drain ne viennent en regard de la grille 124.

De manière particulièrement avantageuse, la présence des espaceurs 410 tend à empêcher à l'épitaxie de remonter en direction de la grille 124. Les espaceurs 410 forment en effet un retour au dessus des extrémités latérales 117 du canal 180, ce retour bloquant une remontée vers le haut de l'épitaxie. Les espaceurs 410 favorisent ainsi la croissance épitaxiale vers le bas.

En utilisant une épitaxie facettée (ie pour laquelle HCl est un gaz vecteur et pour laquelle on alterne le cycle de dépôt de matériau et de gravure), on peut favoriser la croissance épitaxiale de silicium le long des interfaces oxyde par rapport aux interfaces nitrure et ainsi favoriser la croissance vers le bas au détriment de celle le long des espaceurs nitrure. En fonction du taux d'ouverture, de l'épaisseur d'épitaxie désirée, l'homme de l'art jouera sur le rapport entre HCl et gaz porteur de silicium (ie DCS - dichloro-silane ou silane) et sur le rapport entre le nombre de cycles de dépôt le où le gaz porteur de silicium est présent et ceux de gravure le sans gaz porteur de silicium.

Du fait du mouillage préférentiel de l'épitaxie sur l'oxyde de la couche isolante reformée 118 plutôt que sur le nitrure des espaceurs 410, l'épitaxie cyclique avec DCS (dichloro-silane) est envisageable avec formation de facettes sur le nitrure des espaceurs 410, ce qui reste avantageux dans la problématique de diminution des capacités parasites avec la grille 124.

Par ailleurs, la jointure de deux fronts d'épitaxie est favorisée dans le cas de dispositifs avec faible pitch de par exemple 100 nm ou moins. Si les transistors 200 sont proches les uns des autres avec une distance qui les sépare typiquement de deux fois l'épaisseur de silicium que l'on va faire croitre, les épitaxies qui partent d'un dispositif situé à gauche et d'un dispositif situé à droite vont se rejoindre. Si les dispositifs sont trop éloignés les uns des autres, les épitaxies ne se rejoindront pas contrairement à ce qui est dessiné. Le fait que les épitaxies se rejoignent permet de faire ultérieurement atterrir un contact sur une surface plus grande.

La profondeur de la gravure des cavités 440 réalisées à l'étape 230 est adaptée à l'épaisseur souhaitée de la source et du drain 140 en fonction des spécifications électriques. Une épaisseur d'épitaxie importante est favorable pour limiter les résistances d'accès au transistor 200. En revanche, cette épaisseur doit être suffisamment limitée pour ne pas être dans une situation où la source et le drain 140 sont en regard avec l'empilement de grille 160, ce qui augmenterait la capacité parasite.

La profondeur des cavités 440 est également choisie de manière à éviter de former un vide sous l'épitaxie. Avantageusement, la profondeur maximale est comprise entre 10 et 50 nm et de préférence entre 10 et 30 nm. Cette gravure conditionne l'épaisseur des source et drain 140 et donc leur résistance, ce qui est une spécification électrique.

Ces caractéristiques relatives à la profondeur de gravure sont valables pour tous les modes de réalisation suivants qui font intervenir une épitaxie pour remplir les cavités 440.

De manière additionnelle on peut effectuer un dopage des régions de source et drain 140. Ce dopage est par exemple effectué in situ. Ces caractéristiques relatives au dopage sont valables pour tous les modes de réalisation suivants qui font intervenir une épitaxie pour remplir les cavités 440.

Ainsi, l'invention prévoit un transistor dans lequel la couche isolante 118 présente une face inférieure dont la distance d1 par rapport à une face inférieure du substrat 112 prise sous l'empilement de grille est plus importante que la distance d2 entre la face inférieure de la couche isolante 118 et la face inférieure du substrat 112 prise au niveau d'une cavité 440. Ces distances d1 et d2 sont illustrées en figure 4d. De préférence, la différence entre d1 et d2 est supérieure à 10 nm.

La couche isolante 118 forme une marche sous l'empilement de grille 160. Sous l'empilement de grille 160, le substrat 112 remonte au-delà de la hauteur de la face inférieure de la couche isolante 118 reformée prise dans une cavité 440. Ainsi, uniquement sous l'empilement de grille, le substrat comprend un relief 119 en saillie dont les faces sont au contact de la couche isolante 118. Ainsi la face inférieure de la couche isolante 118 et la face supérieure du substrat ne sont pas planes.

Avantageusement, les source et drain 140 s'étendent sur au moins 70% et de préférence de leur hauteur sous la grille de commande. De préférence, ils s'étendent sur au moins 90% de leur hauteur sous la grille de commande. Selon un mode de réalisation non limitatif, la source et le drain présentent chacun une portion au regard de la grille selon une direction parallèle au plan du substrat, la hauteur de ladite portion selon une direction perpendiculaire au plan du substrat est inférieure à 0.3 fois la hauteur de la grille. De préférence cette hauteur est inférieure à 0.1 fois la hauteur de la grille.

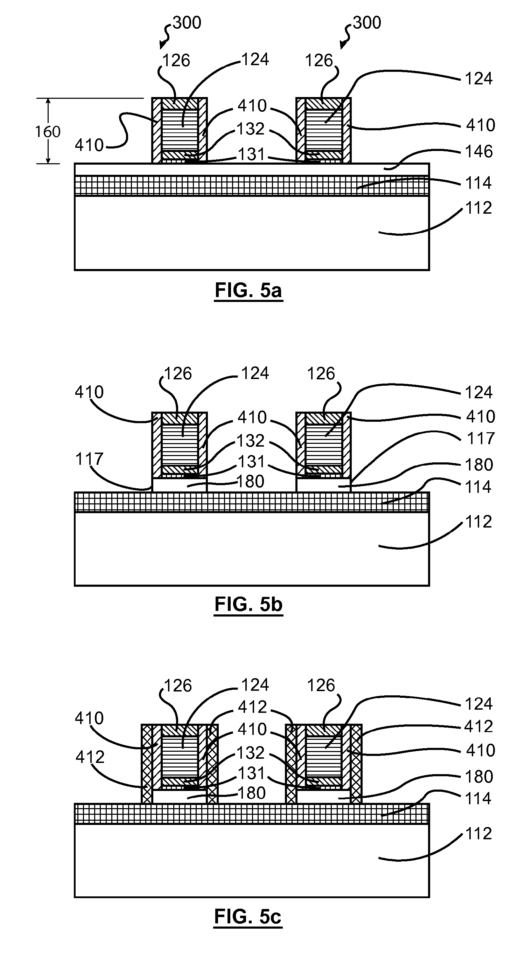

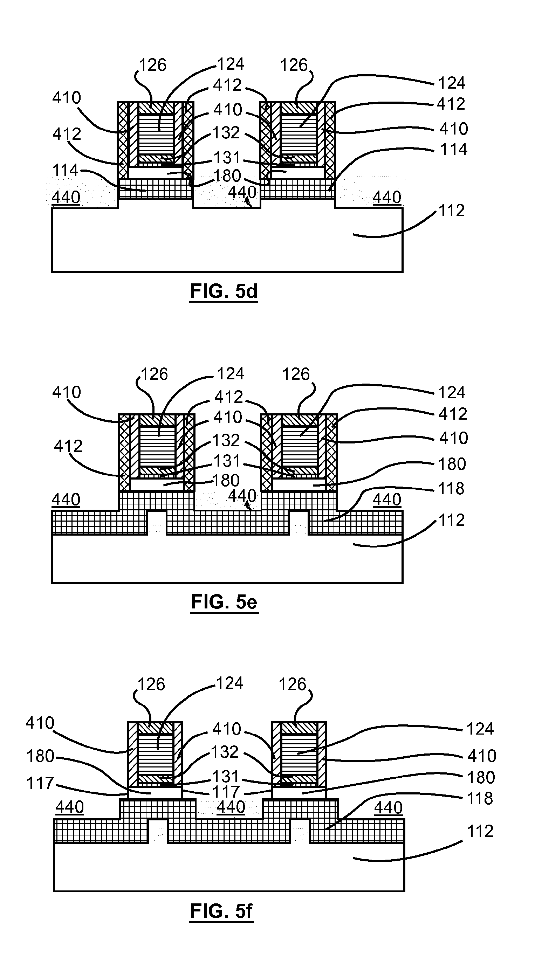

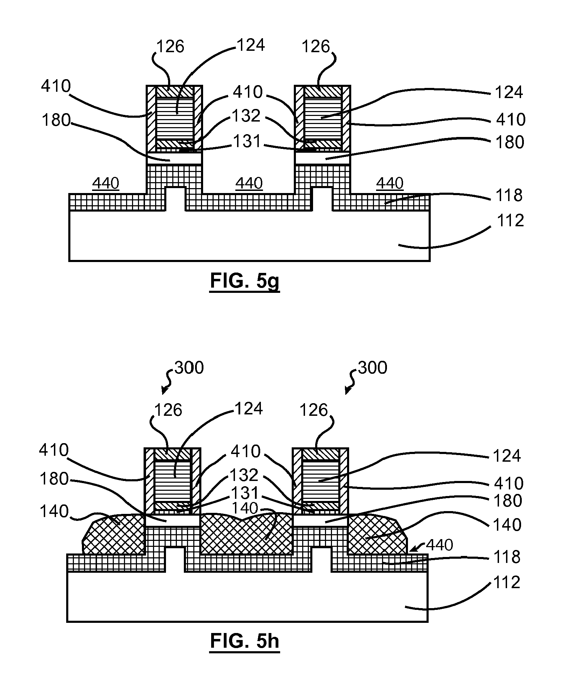

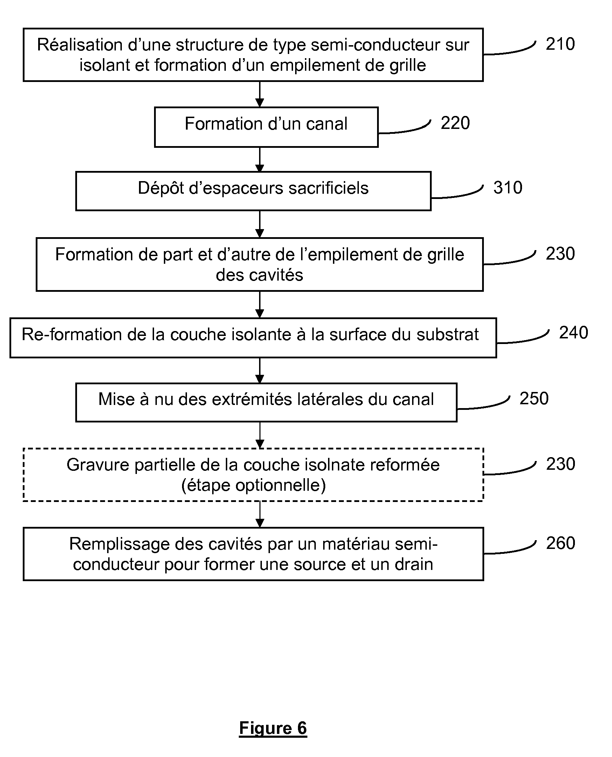

Les **figures 5a à 5h** décrivent des étapes d'un deuxième mode de réalisation selon le procédé de l'invention. La **figure 6** résume les étapes de fabrication d'un transistor 300 selon le deuxième mode de réalisation de l'invention. Les figures 5a, 5b, 5d, 5e, 5f, 5g et 5h, correspondant respectivement aux étapes 210, 220, 230, 240, 250, 230 et 260 de la figure 3 ont été déjà décrites dans la description du premier mode de réalisation.

De manière générale, dans ce mode de réalisation, on prévoit des espaceurs sacrificiels 412 pour empêcher l'oxydation du canal 180 lors de l'étape d'oxydation servant à former une couche isolante 118 continue. Par ailleurs, on prévoit d'autres espaceurs 410 directement au contact de la grille 124 pour protéger cette dernière lors de l'épitaxie. Ces étapes sont présentées plus en détail par la suite.

La figure 5a montre la structure 300 semi-conducteur sur isolant supportant des empilements de grille 160 à l'issue de l'étape 210. Selon ce mode de réalisation, le substrat 112 peut être un substrat dopé ou non-dopé. Comme dans le premier mode de réalisation, un dépôt d'espaceurs 410 est réalisé pour protéger les flancs de l'empilement de grille 160. Ces espaceurs 410 sont par exemple réalisés en nitrure.

La figure 5b montre la structure obtenue à l'issue de l'étape 220. Une gravure anisotrope (de préférence parfaitement anisotrope) dont la direction privilégiée est perpendiculaire au plan du substrat 112, par exemple, une gravure ionique réactive RIE (Reactive-Ion Etching en anglais), est réalisée pour supprimer les parties de la couche active 146 à l'exception des zones se situant en dessous de l'empilement de grille 160. Ces parties de la couche active 146 protégées par le masque dur 126 forment les canaux 180 des transistors 300. La gravure est stoppée lorsque la couche active 146 non protégée est consommée et de préférence avant gravure de la couche isolante initiale 114 de la structure SOI.

La figure 5c montre la structure obtenue à l'issue de l'étape 310 de dépôt de couches de protection formant espaceurs sacrificiels 412 pour l'empilement de grille 160 et pour le canal 180. Les espaceurs sacrificiels 412 couvrent les flancs des espaceurs 410 et du canal 180. Le matériau des espaceurs sacrificiels 412 est, par exemple, un oxyde. Le rôle de cette couche de protection est essentiellement la protection des extrémités latérales 117 du canal 180 lors de la gravure et de l'oxydation qui vont suivre.

La figure 5d montre la structure obtenue à l'issue de l'étape 230. A ce stade, comme mentionné précédemment, la présence du masque dur 126, des espaceurs 410 et des espaceurs sacrificiels 412 servent de protection à l'empilement de grille 160 et au canal 180. Les cavités 440 sont formées par une gravure anisotrope qui attaque préférentiellement les surfaces parallèles au plan du substrat 112 (surfaces horizontales) de la couche isolante initiale 114. La gravure est de préférence parfaitement anisotrope et sa direction privilégiée est perpendiculaire au plan du substrat 112. Les matériaux du masque dur 126, des espaceurs 410 et espaceurs sacrificiels 412 sont choisis de manière à résister à la gravure. Ainsi, toute la couche isolante initiale 114 non protégée par l'empilement de grille 160 est supprimée. Seule subsiste la couche isolante initiale 114 disposée sous le canal 180. De manière préférée une partie supérieure du substrat 112 est également gravée. La profondeur de gravure, par exemple, 5 à 50 nm dans le substrat 112, est à choisir en fonction de la dimension des source et drain 140 formés ultérieurement.

La figure 5e montre la structure obtenue à l'issue de l'étape 240 de reformation d'une couche isolante 118 en surface du substrat 112. Cette étape est effectuée par une oxydation du substrat 112 pour former un film isolant sur les surfaces découvertes du substrat 112. Le canal 180 est protégé par les espaceurs sacrificiels 412 et n'est donc pas oxydé. L'épaisseur d'oxyde au niveau du substrat 112 est préférentiellement plus importante que la largeur des espaceurs sacrificiels 412.

Ainsi, comme pour le mode de réalisation précédent, la formation d'une deuxième couche isolante comprend la formation, par oxydation, d'un film isolant sur toutes les surfaces à nu du substrat 112 et sur toutes les surfaces à nu de la couche active 146 située en dessous de l'empilement de grille. Dans ce mode de réalisation, la couche active 146 située en dessous de l'empilement de grille ne présente pas de surface à nu, puisque les extrémités du canal 180 sont protégées par les espaceurs. Ainsi, seules les surfaces mises à nu du substrat 112 par la gravure sont oxydées.

Selon un mode de réalisation avantageux, l'oxydation du substrat 112 est une oxydation sèche à une température comprise entre 700 et 900°C et de préférence de 800°C.

La figure 5f montre la structure obtenue à l'issue de l'étape 250 de mise à nu des extrémités latérales 117 du canal 180. Ce dégagement des extrémités latérales 117 du canal 180 est réalisé en retirant les espaceurs sacrificiels 412. Les espaceurs sacrificiels 412 sont supprimés par une étape de gravure sélective par rapport aux espaceurs 410. Il faut donc que la solution de gravure attaque le matériau des espaceurs sacrificiels 412 sans pour attaquer les espaceurs 410. On pourra par exemple prévoir pour les espaceurs sacrificiels 412 un matériau en nitrure et pour les espaceurs 410 un oxyde et pour la solution de gravure une gravure acide orthophosphorique.

La figure 5g montre la structure obtenue à l'issue de l'étape 230. Cette étape avantageuse n'est qu'optionnelle. Afin d'avoir une source et un drain 140 plus épais, une étape de gravure d'une partie seulement de la couche isolante 118 est réalisée. Cette gravure isotrope attaque la couche isolante 118 mise à nu, c'est-à-dire la couche isolante 118 ne se situant pas en dessous de l'empilement de grille 160 et des espaceurs 410. L'épaisseur gravée est de préférence de dimension au moins égale à celle des espaceurs sacrificiels 412. Préférentiellement, l'épaisseur gravée est identique à la largeur des espaceurs sacrificiels 412, de sorte que les parois verticales de la couche isolante 118 reformée affleurent les flancs du canal 180 et les flancs des espaceurs 410 recouvrant l'empilement de grille 160.

De manière particulièrement avantageuse, cette étape de gravure partielle de la couche isolante reformée 118 permet d'éviter l'apparition non souhaitée d'un vide à l'étape suivante 260 de remplissage des cavités 440. Comme illustrée sur les figure cette gravure permet de supprimer un coin formé par la couche d'oxyde 118 et qui définissait deux paliers, l'un au niveau de la face inférieure de la couche active 146 et l'autre dans le fond des cavités 440.

Cette gravure est sélective du canal 180. Elle est réalisée, par exemple, à l'acide fluorhydrique. En outre, il est préférable de contrôler la gravure de manière à ne limiter la consommation des tranchées d'isolation de type STI.

La figure 5h montre la structure obtenue à l'issue de l'étape 260 de formation de la source et du drain 140. Les cavités 440 sont remplies par une épitaxie amorcée par le matériau semi-conducteur du canal 180.

Une partie de l'épitaxie peut ne pas être dirigée vers le bas. Quand bien même une partie des S/D s'élève au regard de la grille, l'épaisseur totale des S/D demeure supérieure à, typiquement d'au moins 1.5 fois voire 2 fois, l'épaisseur des S/D au regard de la grille. L'invention reste donc avantageuse.

Les caractéristiques indiquées en description du mode de réalisation illustré en figure 4 à propos de cette étape 260 de la profondeur de gravure et du dopage des régions de source et drain 140 sont valables pour ce mode de réalisation illustré en figure 5.

La structure obtenue avec ce mode de réalisation permet d'obtenir des source et drain 140 enterrés sous la grille 124. Avantageusement, ces source et drain 140 sont auto-alignés avec la grille 124. En outre, elle présente pour avantage de pouvoir utiliser un substrat 112 dopé ou non dopé. Par ailleurs, le canal 180 est protégé lors de l'oxydation servant à reformer la couche isolante reformée 118.

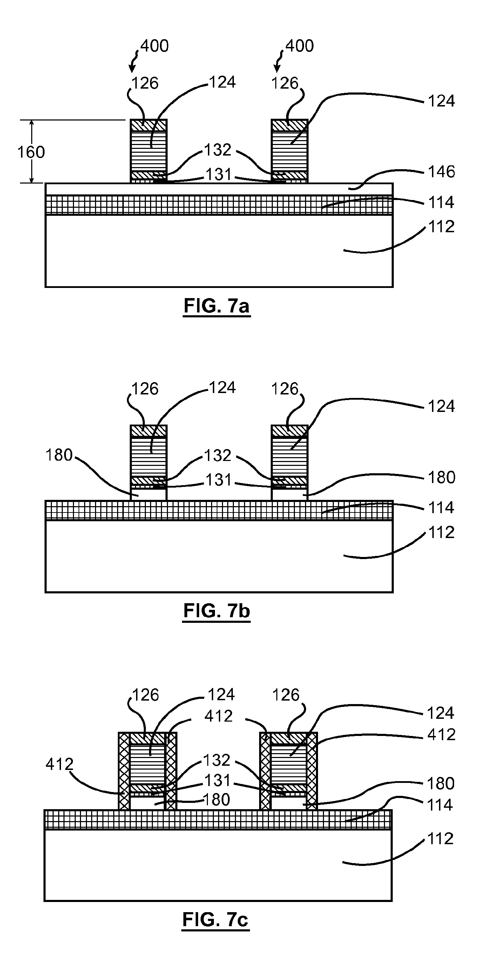

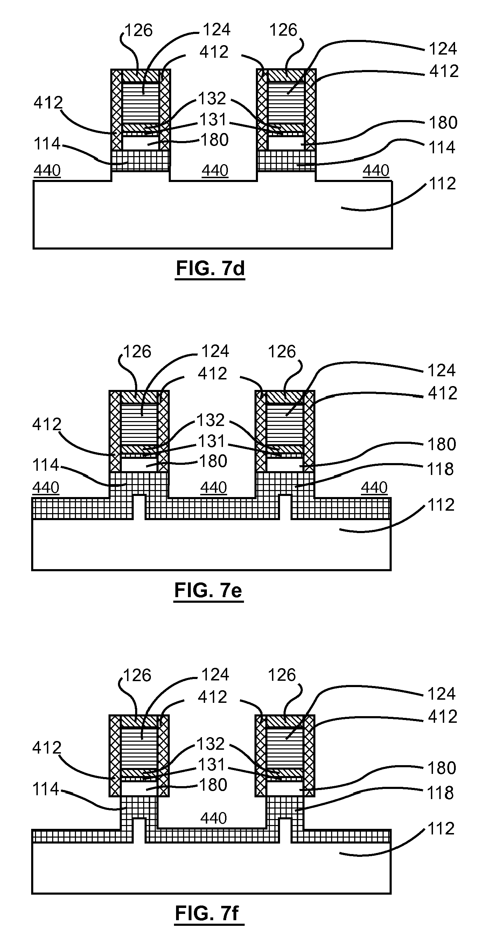

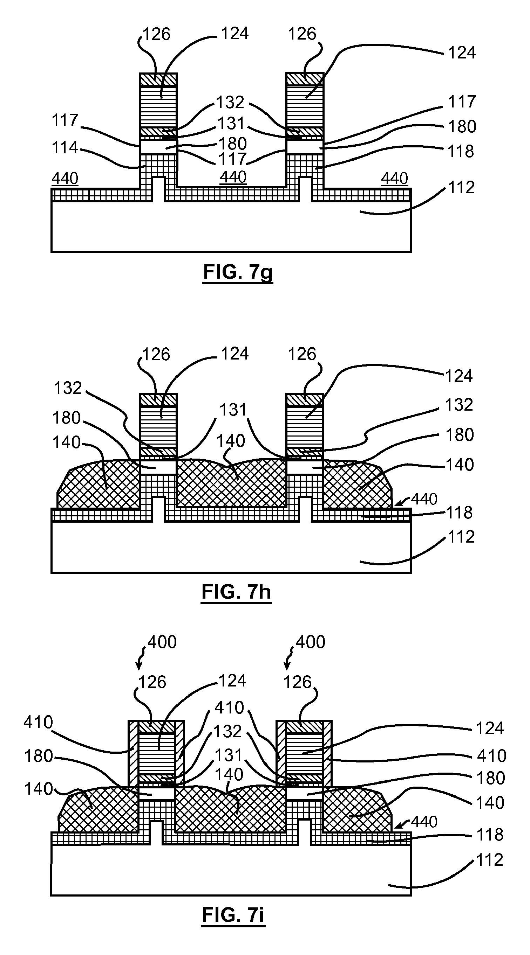

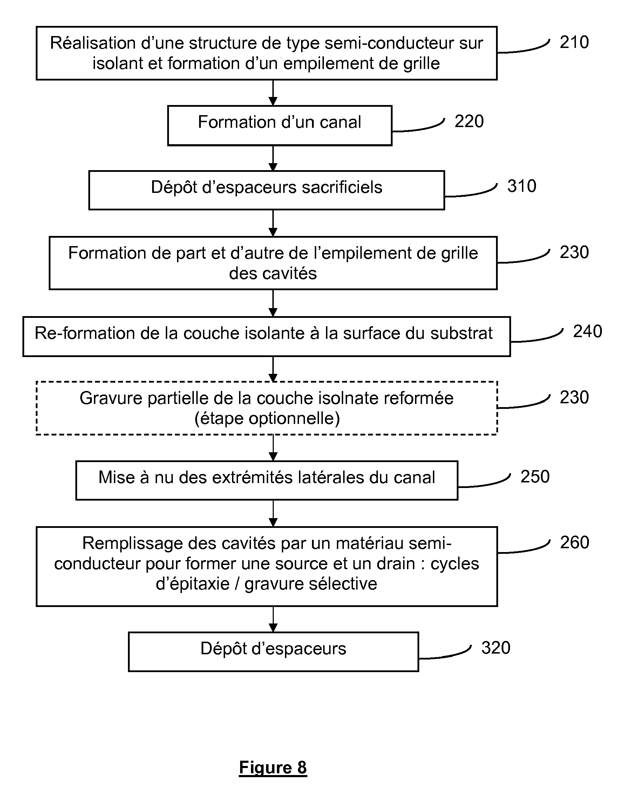

Les **figures 7a à 7i** décrivent des étapes d'un troisième mode de réalisation selon le procédé de l'invention. La **figure 8** résume les étapes de fabrication d'un transistor 400 selon le troisième mode de réalisation de l'invention. Les figures 7a, 7b, 7d, 7e, 7f, 7g et 7h, correspondant respectivement aux étapes 210, 220, 230, 240, 230, 250 et 260 de la figure 3 ont déjà été décrites dans la description dans le premier mode de réalisation. Ce mode de réalisation est préférentiellement adapté pour des oxydes de grille épais.

De manière générale, dans ce mode de réalisation, on prévoit des espaceurs sacrificiels 412 pour empêcher l'oxydation du canal lors de l'étape d'oxydation servant à reformer une couche isolante 118 ininterrompue. Par ailleurs, lors du remplissage des cavités 440 par épitaxie, les flancs de grille ne sont pas protégés et une croissance sur les flancs de la grille 124 est possible. On effectue alors des cycles comprenant une épitaxie suivie d'une étape de gravure du semi-conducteur en croissance sur les flancs de la grille 124 sélectivement au matériau semi-conducteur en croissance à partir du canal 180. On peut par exemple prévoir pour cela un matériau monocristallin pour le canal 180 et un matériau polycristallin pour la grille 124, la gravure choisie étant sélective du matériau polycristallin par rapport au matériau monocristallin.

La figure 7a montre la structure obtenue à l'issue de l'étape 210. Selon le troisième mode de réalisation, le substrat 112 peut être un substrat dopé ou non-dopé. A ce stade aucun espaceur 410 n'est réalisé pour recouvrir des flancs de l'empilement de grille 160.

La figure 7b montre la structure obtenue à l'issue de l'étape 220 de formation du canal 180. Une gravure RIE est réalisée pour enlever la couche active 146 à l'exception des zones se situant en dessous de l'empilement de grille 160. Les zones de la couche active 146 protégées par le masque dur 126 restent en place et forment les canaux 180 des transistors 400. L'arrêt de la gravure s'effectue sur la couche isolante initiale 114.

La figure 7c montre la structure obtenue à l'issue de l'étape 310 de dépôt des espaceurs sacrificiels 412. Les espaceurs sacrificiels 412 doivent couvrir les flancs nus de l'empilement de grille 160 et du canal 180 pour empêcher l'oxydation du canal 180 lors de l'étape de reformation d'une couche isolante 118. Le matériau des espaceurs sacrificiels 412 doit être sélectionné pour être sélectif à la gravure avec le masque dur 126 et avec la couche d'oxyde. Il faut en effet pouvoir graver la couche d'oxyde sans graver les espaceurs sacrificiels 412, il faut pouvoir graver les espaceurs sacrificiels 412 sans graver la couche d'oxyde et il faut pouvoir graver les espaceurs sacrificiels 412 sans pour autant graver le masque dur 126.

Les figures 7d et 7e montrent respectivement les structures de grille à l'issue des étapes 230 et 240. Les descriptions concernant ces étapes sont respectivement identiques à celles concernant la réalisation des étapes 230 et 240 du deuxième mode de réalisation présentées respectivement dans les figures 5d et 5e. A l'issue de ces étapes, un film isolant est réalisé sur les surfaces découvertes du substrat 112 pour reformer avec les portions restantes de la couche isolante initiale 114 une couche isolante 118 ininterrompue à la surface du substrat 112.

La figure 7f montre la structure obtenue à l'issue de l'étape 230. Afin d'avoir une source et un drain 140 plus épais, on effectue une étape de gravure partielle de la couche isolante reformée 118. Cette gravure est isotrope. L'épaisseur gravée est de dimension au moins égale à celle des espaceurs sacrificiels 412.

Ainsi, la couche d'oxyde située au droit des espaceurs sacrificiels 412 est prélevée. La gravure est réalisée, par exemple, à l'acide fluorhydrique.

La figure 7g montre la structure obtenue à l'issue de l'étape 250 de mise à nu des extrémités latérales 117 du canal 180 en enlevant les espaceurs sacrificiels 412. Une gravure RIE est réalisée pour retirer les espaceurs sacrificiels 412 sans retirer la couche active 146 et à la couche isolante reformée 118.

La figure 7h montre la structure obtenue à l'issue de l'étape 260 de formation de la source et du drain 140. Les cavités 440 sont remplies par une épitaxie amorcée par le matériau semi-conducteur du canal 180.

On notera qu'à ce stade, les flancs de la grille 124 sont découverts. Le matériau semi-conducteur de la grille 124 peut donc servir d'amorce à une croissance par épitaxie lors de l'épitaxie des source et drain 140, ce qui n'est naturellement pas souhaité. Au cours de cette étape, on effectue au moins une gravure sélective des zones formées par épitaxie à partir des flancs de la grille 124 par rapport aux zones formées par épitaxie à partir du canal 180. Comme brièvement indiqué ci-dessous, on peut par exemple prévoir pour un matériau monocristallin (silicium monocristallin par exemple) pour former le canal 180 et un matériau polycristallin (silicium polycristallin par exemple) pour la grille 124. La solution de gravure est choisie pour être sélective du matériau polycristallin par rapport au matériau monocristallin. Il s'agit par exemple d'une gravure chimique humide telle qu'une gravure au chlorure d'hydrogène (HCl).

De manière préférée mais optionnelle, au lieu d'effectuer une épitaxie unique et une gravure unique du semi-conducteur développé sur les flancs de la grille 124, on effectue plusieurs cycles comprenant chacun une seule épitaxie suivie d'une seule étape de gravure du semi-conducteur en croissance sur les flancs de la grille 124 sélectivement au matériau semi-conducteur en croissance à partir du canal 180. On effectue par exemple 20 cycles, pour des gravures de 2 à 3 nm/cycle et pour des source et drain 140 d'épaisseur comprise entre 10 et 30 nm.

On pourra par exemple se référer à la publication suivante Low temperature Si:C co-flow and hybrid process using Si3H8/Cl2 de Bauer and S.G. Thomas TSF_2011, publié dans Thin Solid Films 520 (2012) 3133-3138.

Ce mode de réalisation est particulièrement bien adapté aux transistors 400 dont l'oxyde 131 de la grille 124 est épais, puisque cela tend à éloigner la grille 124 du canal 180 et donc des source et drain 140, limitant de ce fait les risques de courts-circuits.

Il convient de noter que, comme mentionné précédemment, on effectue l'épitaxie de manière à ce qu'elle soit dirigée vers le bas.

Les caractéristiques indiquées en description du mode de réalisation illustré en figure 4 à propos de cette étape 260 de remplissage des cavités 440, de la profondeur de gravure et du dopage des régions de source et drain 140 sont valables pour ce mode de réalisation illustré en figure 7h.

La figure 7i montre la structure obtenue à l'issue de l'étape 320 de dépôt d'espaceurs 410 pour recouvrir les flancs de l'empilement de grille 160. Cette étape d'encapsulation de la grille 124 n'est pas limitative de l'invention.

La structure obtenue avec ce mode de réalisation permet d'obtenir des source et drain 140 enterrés sous la grille 124. Avantageusement, ces source et drain 140 sont auto-alignés avec la grille 124. En outre, elle présente pour avantage de pouvoir utiliser un substrat 112 dopé ou non dopé. Par ailleurs, le canal 180 est protégé lors de l'oxydation servant à reformer la couche isolante 118.

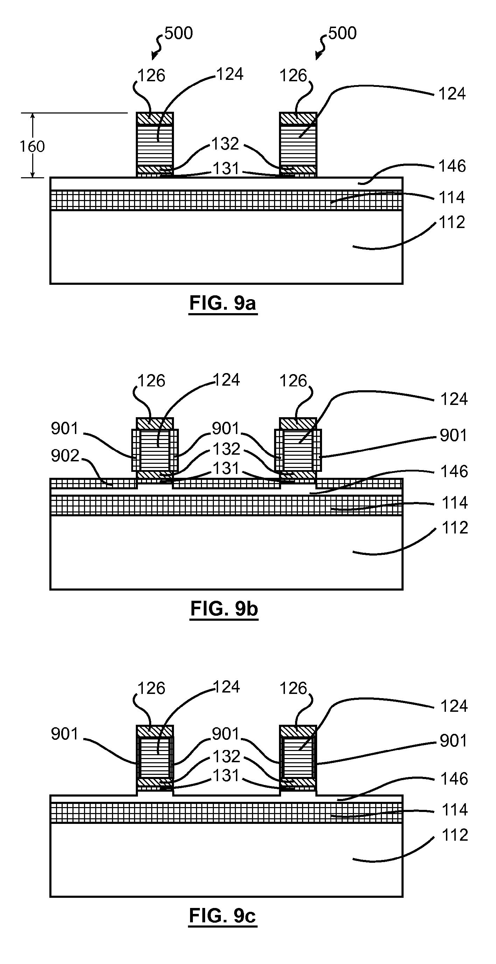

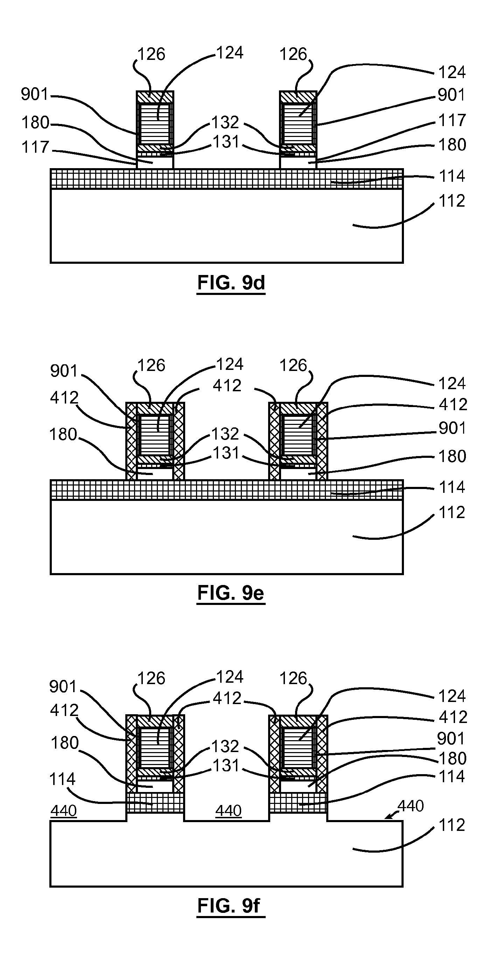

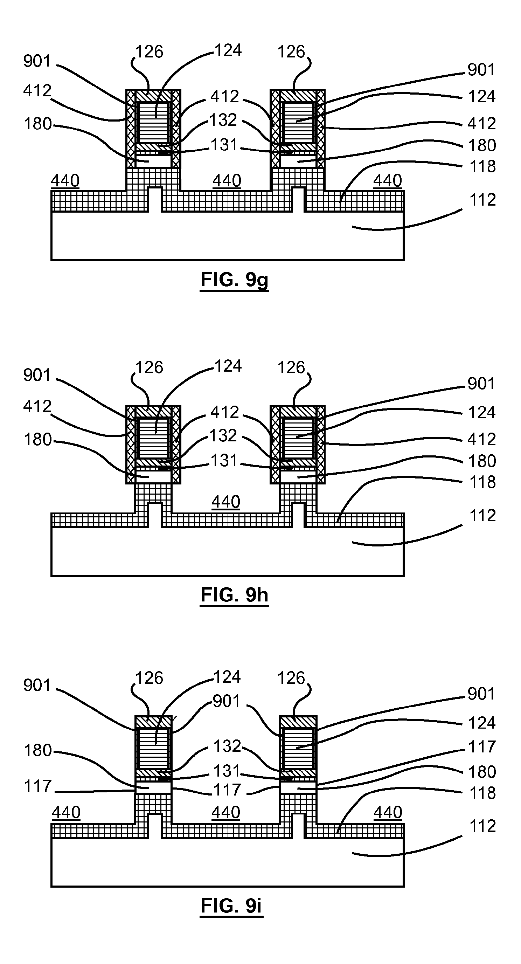

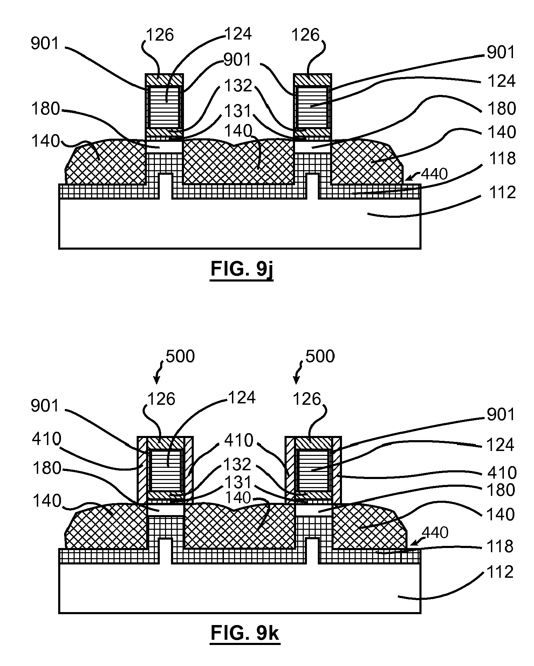

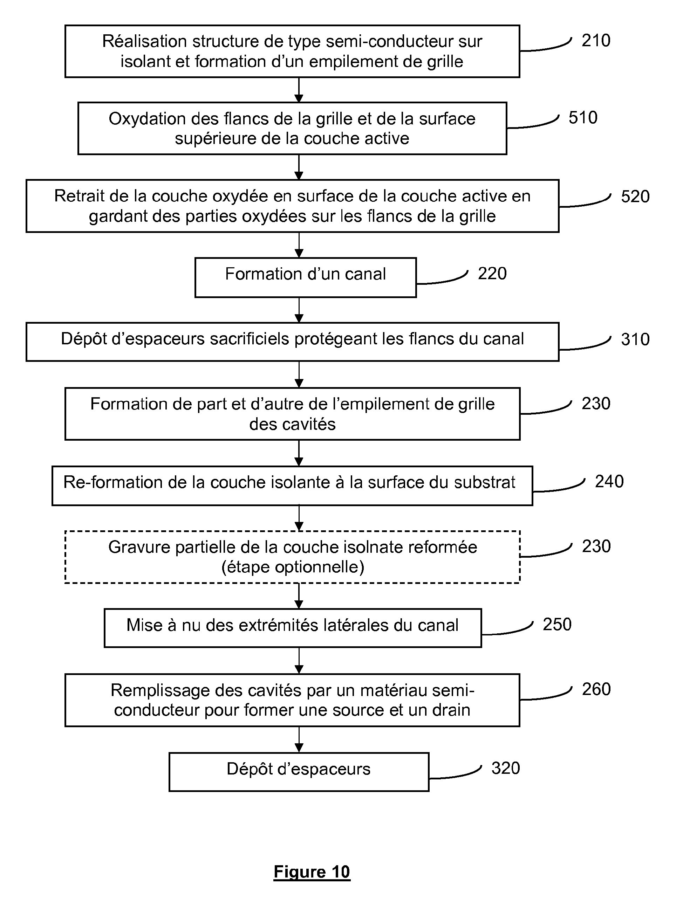

Ensuite, les **figures 9a à 9k** décrivent des étapes d'un quatrième mode de réalisation selon le procédé de l'invention. La **figure 10** résume les étapes de fabrication d'un transistor selon le quatrième mode de réalisation de l'invention. Les figures 9a, 9d, 9f, 9g, 9h, 9i et 9j, correspondant respectivement aux étapes 210, 220, 230, 240, 230, 250 et 260 de la figure 3 ont été déjà décrites dans la description du premier mode de réalisation. Ce mode de réalisation est préférentiellement adapté pour les oxydes de grille épais.

De manière générale, dans ce mode de réalisation, on prévoit par rapport au mode de réalisation précédent, de protéger la grille 124 par une oxydation de ses flancs afin d'éviter une croissance par épitaxie à partir des flancs de la grille 124 lors de l'étape de reformation de la couche isolante 118 à la surface du substrat 112.

La figure 9a montre la structure 500 obtenue à l'issue de l'étape 210. Selon ce quatrième mode de réalisation, le substrat 112 peut avantageusement être dopé ou non-dopé. A ce stade aucun espaceur 410 n'est réalisé pour protéger les flancs de l'empilement de grille 160.

La figure 9b montre la structure obtenue à l'issue de l'étape 510. A ce stade, des flancs de la grille 124 et des parties supérieures de la couche active 146 à l'exception des zones se situant en dessous de l'empilement de grille 160 sont oxydés de préférence par une oxydation thermique. Ces oxydations forment sur les flancs de la grille 124 les couches référencées 901 sur la figure 9b et forment à la surface du substrat 112 la couche référencée 902. Avantageusement, un large choix de procédés d'oxydation peut être utilisé. En effet, il n'y a pas besoin de recourir à des procédés d'oxydation préférentiel d'une couche par rapport à une autre. L'épaisseur des parties oxydées est de préférence comprise entre 1 et 5 nm.

La figure 9c montre la structure obtenue à l'issue de l'étape 520. Une gravure anisotrope (de préférence parfaitement anisotrope) dont la direction privilégiée est perpendiculaire au plan du substrat 112 est réalisée. Cette gravure est sélective par rapport au masque dur 126. Elle est donc auto-alignée sur la grille 124. Toute l'épaisseur d'oxyde 902 présente à la surface du substrat 112 est retirée. En revanche, la partie oxydée 901 présente sur les flancs de la grille 124 est située en dessous du maque dur 126 (donc protégée par cette dernière) n'est pas gravée. Il reste ainsi de l'oxyde 901 sur les flancs de la grille 124.

Par exemple, on peut recourir à une gravure de type RIE.

La figure 9d montre la structure obtenue à l'issue de l'étape 220 de formation du canal 180. Une gravure RIE est réalisée pour enlever l'épaisseur restante des parties de la couche active 146 mise à nu, c'est-à-dire les parties qui ne sont pas situées en dessous de l'empilement de grille 160. Les portions de la couche active 146 protégées par le masque dur 126 restent en place et sont destinées à former les canaux 180 des transistors 500.

Les figures 9e, 9f, 9g, 9h, 9i montrent respectivement les structures de grille à l'issue des étapes 310, 230, 240, 230 et 250. Les descriptions concernant ces étapes sont respectivement identiques à celles concernant la réalisation des étapes 310, 230, 240, 230 et 250 du troisième mode de réalisation étant présentées respectivement dans les figures 7c, 7d, 7e, 7f, 7g. Ainsi, la structure obtenue à l'issue de ces étapes présente un substrat 112 surmontée d'une couche isolante 118 ininterrompue au moins pour un transistor 500. L'empilement de grille 160 présente de part et d'autre des cavités 440 électriquement isolées du substrat 112 par la couche isolante reformée 118. Le canal 180 de chaque transistor 500 est disposé au sommet du relief formé entre deux cavités 440 successives. Les extrémités latérales 117 du canal 180 sont à nu. Une couche d'oxyde 901 recouvre les flancs de la grille 124.

La figure 9j montre la structure obtenue à l'issue de l'étape 260 de formation de la source et du drain 140. Les cavités 440 sont remplies par une épitaxie amorcée par le matériau semi-conducteur du canal 180. Il convient de noter que les flancs de la grille étant protégés par la couche d'oxyde 901, il n'y a pas d'épitaxie qui se forme sur les flancs de la grille 124, comme cela était le cas pour le mode de réalisation précédent.

Les caractéristiques indiquées en description du mode de réalisation illustré en figure 4 à propos de cette étape 260 de remplissage des cavités 440, de la profondeur de gravure et du dopage des régions de source et drain 140 sont valables pour ce mode de réalisation illustré en figure 9j.

Après épitaxie, on réalise de préférence des espaceurs 410 comme cela avait été indiqué à propos de l'étape 320 illustrée en figure 7i.

Comme pour le procédé précédent, le procédé illustré en figure 9 et 10 présente pour avantage de pouvoir utiliser un substrat 112 dopé ou non dopé. Par ailleurs, le canal est protégé lors de l'oxydation servant à reformer la couche isolante 118. Ce procédé permet en outre d'éviter la croissance par épitaxie à partir des flancs de la grille 124. Les source et drain 140 sont auto-alignés avec la grille.

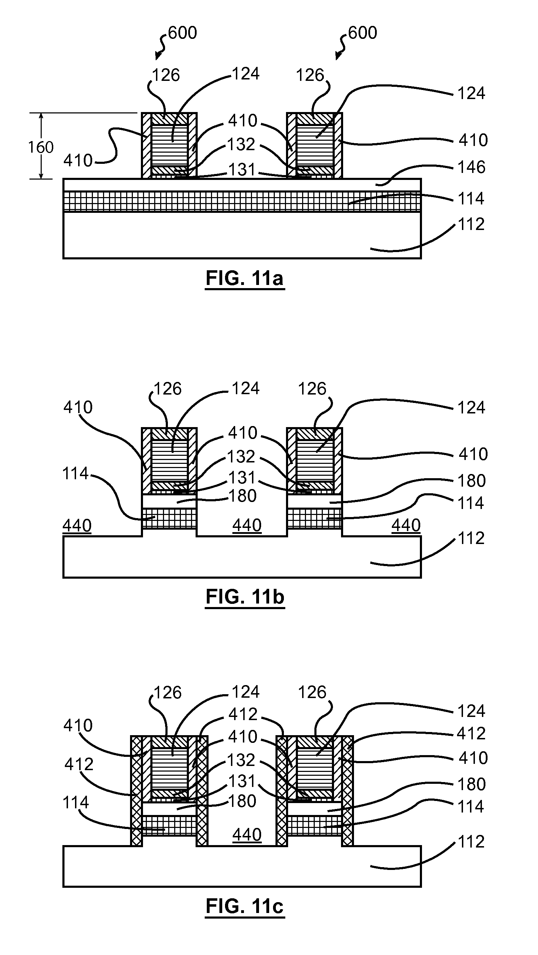

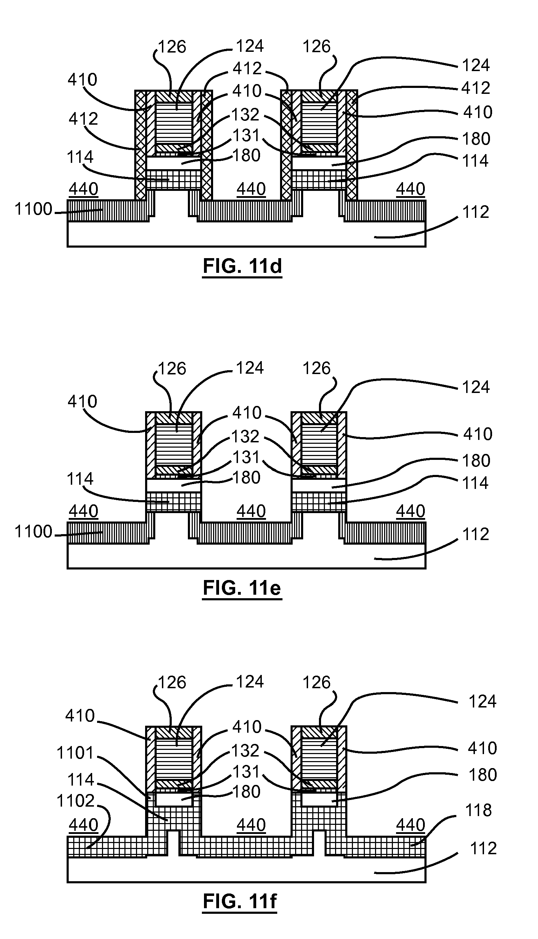

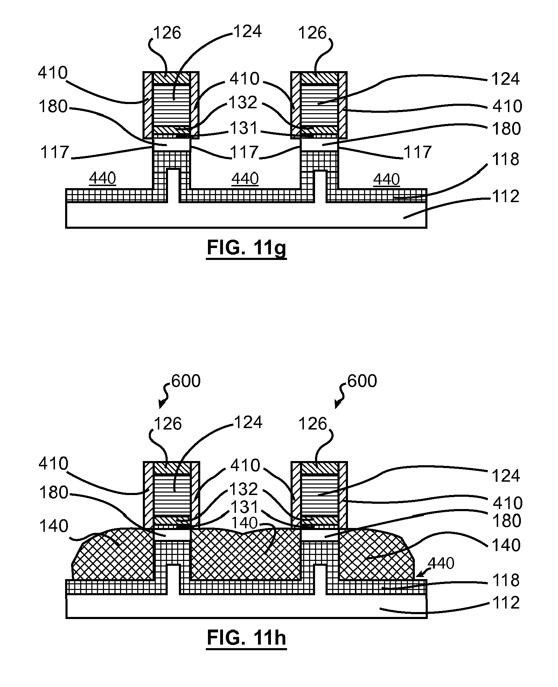

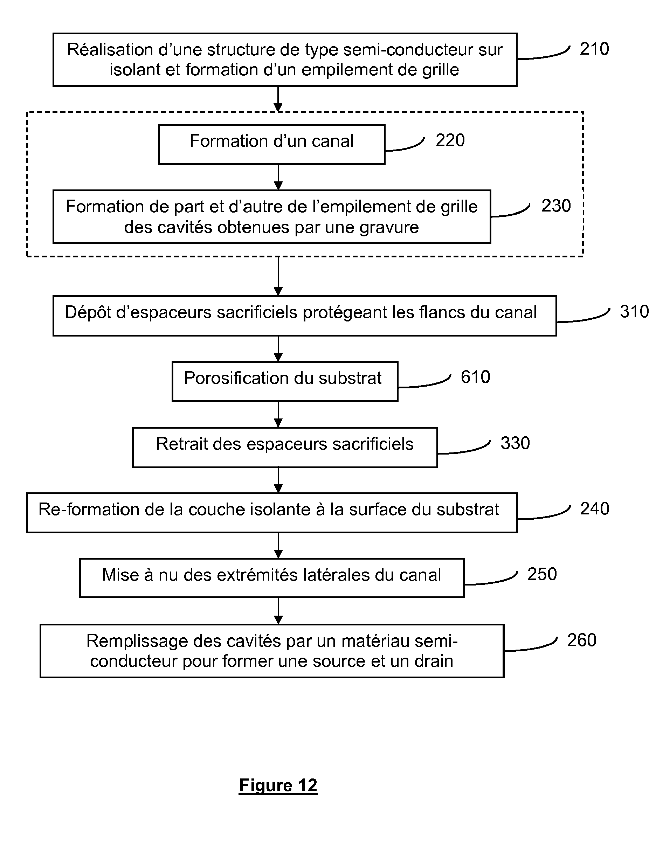

Les **figures 11a à 11h** décrivent des étapes d'un cinquième mode de réalisation selon le procédé de l'invention. La **figure 12** résume les étapes de fabrication d'un transistor 600 selon le cinquième mode de réalisation de l'invention. Les figures 11a, 11 b, 11 f, 11 g et 11h, correspondant respectivement aux étapes 210, 220 et 230, 240, 250 et 260 de la figure 3 ont été déjà décrites dans la description du premier mode de réalisation.

Dans ce mode de réalisation, on reforme une couche isolante 118 continue par oxydation alors même que les extrémités latérales 117 du canal 180 ne sont pas protégées. Pour cela on rend poreuse la surface du substrat 112 et on effectue une oxydation préférentielle du matériau semi-conducteur poreux du substrat 112 par rapport au matériau semi-conducteur non poreux formant le canal 180.

Pour rendre poreuse la surface du substrat 112, il faut au moins qu'un le courant puisse traverser le substrat 112. Le substrat 112 est donc préférentiellement un substrat dopé dont le niveau de dopage est élevé, afin d'assurer le passage du courant et de pouvoir ensuite oxyder préférentiellement le substrat 112 dans une étape ultérieure. La nature et le niveau de dopage quant à eux modifient la morphologie des pores.

Les figures 11a et 11 b montrent respectivement les structures à l'issue des étapes 210, 220 et 230. Les descriptions concernant ces étapes sont respectivement similaires/identiques à celles concernant la réalisation des étapes 210, 220 et 230 du premier mode de réalisation, étapes présentées respectivement aux figures 4a et 4b. Comme dans le premier mode de réalisation, la formation du canal 180 (l'étape 220) et la formation de part et d'autre de l'empilement de grille 160 et des cavités 440 (l'étape 230) sont réalisées par une gravure anisotrope auto-alignée par rapport à l'empilement de grille 160. De préférence on effectue une seule gravure pour graver la couche active 146, la couche isolante initiale 114 et éventuellement une portion du substrat 112. De même que pour les modes de réalisation précédents, cette épaisseur gravée dans le substrat 112 est avantageusement comprise entre 5 et 50 nm.

La figure 11 c montre la structure obtenue à l'issue de l'étape 310 de dépôt d'espaceurs sacrificiels 412. Les espaceurs sacrificiels 412 doivent être déposés dans le sens vertical par rapport au substrat 112 pour couvrir les flancs nus des espaceurs 410, du canal 180. Ils peuvent également couvrir les flancs des portions restantes de la couche isolante initiale 114. Le matériau des espaceurs sacrificiels 412 doit être sélectif à la gravure par rapport aux espaceurs 410, au masque dur 126 et au substrat 112.

La figure 11 d montre la structure de grille à l'issue de l'étape 610 de porosification du substrat 112. Les espaceurs sacrificiels 412 protègent les flancs du canal 180 et ceux de la couche isolante initiale 114 qui ne sont donc pas affectés par cette porosification. De plus, le canal 180 est isolé électriquement par la couche isolante initiale 114. Ainsi, le canal 180 ne devient pas poreux et seul le substrat 112 est localement poreux. La couche superficielle du substrat 112 rendu poreux est référencée 1100 sur les figures 11 d et 11 e. Cette étape de porosification est par exemple une porosification électrolytique par acide fluorhydrique. La dimension des pores est, par exemple de 5 nm.

La figure 11e montre la structure obtenue à l'issue de l'étape 330 de retrait des espaceurs sacrificiels 412. Cette étape est réalisée par une gravure sélective des espaceurs sacrificiels 412 par rapport aux espaceurs 410, au masque dur 126 et au substrat 112 rendu poreux.

La figure 11f montre la structure obtenue à l'issue de l'étape 240 de reformation d'une couche isolante 118 ininterrompue à la surface du substrat 112. A ce stade, les extrémités latérales 117 du canal 180 sont découvertes. Elles sont donc affectées par l'oxydation. En revanche la cinétique d'oxydation du matériau semi-conducteur non poreux est plus faible que celle du matériau semi-conducteur poreux 1100 recouvrant le substrat 112. L'oxydation est donc une oxydation préférentiellement du matériau semi-conducteur du substrat 112 par rapport au matériau semi-conducteur du canal 180. De préférence, une oxydation de type sèche est effectuée pour former une faible épaisseur d'oxyde 1101 au niveau du canal 180. L'oxydation 1102 du substrat 112 est de préférence au moins deux fois plus importante que celle 1101 du canal 180.

Les figures 11g et 11h montrent les structures de grille à l'issue des étapes 250 et 260. Les descriptions concernant ces étapes sont identiques à celles concernant la réalisation des étapes 250 et 260 du premier mode de réalisation, étapes décrites en référence aux figures 4d et 4e. Ainsi à ces étapes les extrémités latérales 117 du canal 180 sont dégagées et les régions de source et drains 140 sont formées par épitaxie à partir du canal 180. Les caractéristiques indiquées en description du mode de réalisation illustré en figure 4 à propos de ces étapes 250 et 260, de mise à nu du canal 180, de remplissage des cavités 440, de la profondeur de gravure et du dopage des régions de source et drain 140 sont valables pour ce mode de réalisation illustré en figures 11 g et 11h.

En outre il convient de noter que ce mode de réalisation a également pour avantage, comme le mode de réalisation illustré en figure 4, de présenter des espaceurs 410 qui bloquent une croissance de l'épitaxie vers le haut à partir du canal 180. Ce mode de réalisation permet donc de faciliter une croissance vers le bas grâce à l'existence des espaceurs 410 qui surplombent les extrémités latérales 117 du canal 180. Avantageusement, les source et drain 140 sont auto-alignés avec la grille 124.

La description détaillée qui précède fait clairement apparaître que l'invention propose une solution efficace pour réduire la résistance d'accès des électrodes des S/D sans dégrader les performances du transistor, notamment en termes de vitesse.

Un avantage significatif qu'elle présente réside dans le fait que la hauteur des S/D est indépendante de l'épaisseur de la couche active formant le canal.

En outre, l'invention permet d'auto-aligner les cavités et donc les S/D autour de l'empilement de grille.

L'invention n'est pas limitée aux modes de réalisation précédemment décrits mais s'étend à tout mode de réalisation entrant dans la portée définie par les revendications.

## Revendications

1. Procédé de fabrication d'un transistor comprenant la formation d'un empilement de couches de type semi-conducteur-sur-isolant comportant au moins un substrat (112), surmonté d'une première couche isolante (114) et d'une couche active (146) destinée à former un canal (180) pour le transistor, le procédé comprenant en outre la formation d'un empilement de grille (160) sur la couche active (146) et la réalisation d'une source et d'un drain (140), **caractérisé en ce que** la réalisation de la source et du drain (140) comprend au moins les étapes suivantes:
la formation de part et d'autre de l'empilement de grille (160) de cavités (440) par au moins une étape de gravure de la couche active (146), de la première couche isolante (114) et d'une partie du substrat (112) sélectivement à l'empilement de grille (160) au moins de manière à retirer, en dehors de zones situées en dessous de l'empilement de grille (160), toute la couche active (146) découverte, la première couche isolante (114) et une portion du substrat (112),
la formation d'une deuxième couche isolante (118) comprenant la formation par oxydation du substrat (112) d'un film isolant sur toutes les surfaces mises à nu du substrat (112) par ladite gravure, de manière à ce que le film isolant forme avec la première couche isolante (114) une couche isolante continue d'une cavité (440) à l'autre du transistor;
la mise à nu des extrémités latérales (117) du canal (180) formé par la portion de couche active (146) laissée en place sous l'empilement (160) de grille;
le remplissage des cavités (440) par un matériau semi-conducteur par épitaxie à partir des extrémités latérales (117) du canal (180) de manière à former la source et le drain (140).

2. Procédé selon la revendication précédente dans lequel la formation du film isolant comprend l'oxydation de toutes les surfaces à nu de la couche active (146) située en dessous de l'empilement de grille (160).

3. Procédé selon l'une quelconque des revendications précédentes dans lequel la deuxième couche isolante (118) est continue sur l'ensemble de la plaque ou tout au moins pour une pluralité de transistors.

4. Procédé selon l'une quelconque des revendications précédentes comprenant, après l'étape d'oxydation du substrat (112), une étape de gravure partielle de la deuxième couche isolante (118), et dans lequel l'épitaxie est effectuée de manière à ce que l'épaisseur des source et drain (140) réalisés par épitaxie présentent chacun une dimension Ep(epi) sensiblement égale à Ep(gravée1) - 0,54.EP(oxyde) + Ep(gravée2), avec : Ep(gravée1) correspond à l'épaisseur gravée lors de la formation des cavités (440); EP(oxyde) correspond à l'épaisseur du film isolant formé par oxydation sur le substrat (112); Ep(gravée2) correspond à l'épaisseur gravée lors de l'étape de gravure partielle de la deuxième couche isolante (118).

5. Procédé selon l'une quelconque des revendications précédentes dans lequel l'étape de formation de la deuxième couche isolante (118) par oxydation du substrat (112) comprend l'oxydation des extrémités latérales (117) du canal (180).

6. Procédé selon la revendication précédente comprenant, après l'étape d'oxydation, une étape de gravure partielle isotrope de la deuxième couche isolante (118), la gravure partielle étant réalisée de manière à mettre à nu les extrémités latérales (117) du canal (180) et à ce que la deuxième couche isolante (118) demeure ininterrompue d'une cavité (440) à l'autre du transistor.

7. Procédé selon l'une quelconque des revendications 4 ou 6 comprenant, préalablement à l'étape de formation des cavités (440), une étape de formation d'au moins une couche de protection (410) disposée sur des flancs de la grille (124), la gravure partielle de la deuxième couche isolante (118) étant sélective de ladite couche de protection (410) de manière à ce qu'après l'étape de gravure partielle les extrémités latérales (117) du canal (180) soient en retrait par rapport à la couche de protection (410).

8. Procédé selon l'une quelconque des deux revendications précédentes dans lequel l'étape de formation de la deuxième couche isolante (118) comprend une étape d'oxydation thermique du substrat (112) préférentiellement au canal (180), de préférence, dans lequel le substrat (112) présente un dopage supérieur à la couche active (146) et de préférence dans lequel le dopage du substrat (112) favorise l'oxydation du substrat (112) par rapport à l'oxydation du canal (180).

9. Procédé selon l'une quelconque des revendications 1 à 7 dans lequel l'étape de formation de la deuxième couche isolante (118) comprend les étapes suivantes :
- après la formation des cavités (440), formation d'au moins une couche de protection sacrificielle (412) masquant les flancs de l'empilement de grille (160), les extrémités latérales (117) du canal (180) et des flancs de la première couche isolante (114), la couche de protection sacrificielle (412) laissant à nu le substrat (112) dans le fond des cavités (440), la couche de protection sacrificielle (412) étant choisie de manière à isoler au moins le canal (180) d'une porosification électrolytique ;
- porosification électrolytique du substrat (112) ;
- mise à nu des extrémités latérales (117) du canal (180) par retrait de la couche de protection sacrificielle (412) ;
- oxydation thermique du substrat (112) préférentiellement au canal (180).

10. Procédé selon l'une quelconque des revendications 1 à 4 comprenant, préalablement à l'étape de formation de la deuxième couche isolante (118), une étape de formation d'une couche de protection sacrificielle (412) disposée de manière à protéger au moins les extrémités latérales (117) du canal (180) lors de l'étape d'oxydation pour former la deuxième couche isolante (118) et comprenant, avant l'étape de remplissage des cavités (440), une étape de retrait de la couche de protection sacrificielle (412) pour mettre à nu les extrémités latérales (117) du canal (180), dans lequel, la formation des cavités comprend de préférence : une étape de gravure de la couche active (146) sélective de l'empilement de grille (160) avec arrêt de gravure à la surface de la première couche isolante (114) et une étape de gravure de la première couche isolante (114) avec arrêt sur ou dans le substrat (112), dans lequel l'étape de formation de la couche de protection sacrificielle (412) est de préférence effectuée après ladite étape de gravure de la couche active (146) et avant ladite étape de gravure de la première couche isolante (114).

11. Procédé selon la revendication précédente comprenant, après l'étape d'oxydation pour former la deuxième couche isolante (118), une étape de gravure partielle de la deuxième couche isolante (118).

12. Procédé selon la revendication précédente dans lequel l'étape de gravure partielle de la deuxième couche isolante (118) est une gravure isotrope et l'épaisseur gravée est au moins égale à la largeur de la couche de protection sacrificielle (412).

13. Procédé selon la revendication précédente dans lequel l'étape de retrait de la couche de protection sacrificielle (412) est effectuée avant ladite étape de gravure partielle de la deuxième couche isolante (118).

14. Procédé selon la revendication 12 dans lequel l'étape de retrait de la couche de protection sacrificielle (412) est effectuée après ladite étape de gravure partielle de la deuxième couche isolante (118) et dans lequel l'étape de retrait de la couche de protection sacrificielle (412) est de préférence effectuée avant l'étape de remplissage des cavités (440), de préférence le procédé comprenant en outre, après l'étape de remplissage des cavités (440), une étape de formation d'au moins un espaceur (410) de part et d'autre de l'empilement de grille (160) et au contact de l'empilement de grille (160).

15. Procédé selon la revendication précédente dans lequel la couche de protection sacrificielle (412) est disposée directement au contact des flancs de l'empilement de grille (160) et dans lequel de préférence les flancs de la grille (124) sont à nu au début de l'étape de remplissage, les structures cristallines de la grille (124) et du canal (180) sont différentes et dans lequel l'étape de remplissage des cavités (440) comprend une pluralité de cycles comprenant chacun :
- une épitaxie amorcée à partir du canal (180) et à partir des flancs de la grille (124);
- une gravure d'un matériau en croissance épitaxiale à partir des flancs de la grille (124) sélectivement à matériau en croissance épitaxiale à partir du canal (180).

16. Procédé selon la revendication 14 comprenant, avant l'étape de formation de la couche de protection sacrificielle (412), une étape de protection des flancs de la grille (124) comprenant une oxydation des flancs de la grille (124), les flancs de la grille (124) conservant une couche oxydée (901) lors de l'étape de remplissage des cavités (440).

17. Procédé selon l'une quelconque des revendications précédentes dans lequel au niveau des cavités (440), la face supérieure du film isolant se situe en dessous de la face inférieure de la couche active (146) formant le canal (180).
